# EUROPEAN PATENT APPLICATION

(11) **EP 4 583 170 A1**
(43) Date of publication of application: **09.07.2025**
(21) Application number: 22963565.1
(22) Date of filing: 26.10.2022
(51) Int. Cl.: H01L 33/20, H01L 33/36, H01L 27/12, H01L 33/44, H01L 33/48, H01L 33/00, H01L 25/075

(54) **SEMICONDUCTOR LIGHT-EMITTING DEVICE, DISPLAY APPARATUS INCLUDING SEMICONDUCTOR LIGHT-EMITTING DEVICE, AND MANUFACTURING METHOD THEREFOR**

(71) Applicant: LG Electronics Inc., Yeongdeungpo-gu Seoul 07336 (KR)
(72) Inventor: PARK, Sungmin, Seoul 06772 (KR); CHO, Byoungkwon, Seoul 06772 (KR); CHOI, Wonseok, Seoul 06772 (KR); KWON, Jeonghyo, Seoul 06772 (KR); JUNG, Jinhyuk, Seoul 06772 (KR)
(74) Representative: Vossius & Partner Patentanwälte Rechtsanwälte mbB
(86) International application number: PCT/KR2022/016452
(87) International publication number: WO 2024/090604

(57) **Abstract**

According to embodiments, provided is a semiconductor light-emitting device including: a first-conductivity-type electrode layer; a first-conductivity-type semiconductor layer electrically connected to the first-conductivity-type electrode layer and disposed on the first-conductivity-type electrode layer; an active layer disposed on the first-conductivity-type semiconductor layer; a second-conductivity-type semiconductor layer disposed on the active layer and including an upper surface, a connection surface having a first angle to the upper surface and formed adjacent to the upper surface, and a side surface having a second angle to the connection surface and formed adjacent to the connection surface; and a second-conductivity-type electrode layer electrically connected to the second-conductivity-type semiconductor layer and disposed on at least a portion of the upper surface of the second-conductivity-type semiconductor layer.

## Description

### [Technical Field]

Embodiments relate to a semiconductor light emitting element, a display device including the semiconductor light emitting element, and a method for manufacturing the display device. For example, the embodiments are applied to a vertical semiconductor light emitting element, a display device including the vertical semiconductor light emitting element, and a method for manufacturing the display device.

### [Background]

In a field of a display technology, display devices having excellent characteristics such as thinness, flexibility, and the like have been developed. On the other hand, currently commercialized major displays are represented by a LCD (liquid crystal display) and an OLED (organic light emitting diode).

On the other hand, LED (light emitting diode), which is a well-known semiconductor light emitting element that converts electric current into light, has been used as a light source for a display image of an electronic device including an information and communication device along with a GaP:N-based green LED, starting with commercialization of a red LED using a GaAsP compound semiconductor in 1962. Accordingly, a method for solving the above-described problems by implementing a display using the semiconductor light emitting element may be proposed. Such light emitting diode has various advantages, such as long lifespan, low power consumption, excellent initial driving characteristics, high vibration resistance, and the like, compared to a filament-based light emitting element.

The display device is a light emitting device that includes a plurality of such semiconductor light emitting elements. Recently, various methods for manufacturing the display device by mounting such the plurality of such semiconductor light emitting elements on a substrate have been proposed. For example, as the method for manufacturing the display device, a pick & place method using a transfer substrate, a method for assembling the semiconductor light emitting elements onto the substrate using an electric field and/or a magnetic field in a fluid, and the like have been proposed.

However, in the process of assembling the semiconductor light emitting elements onto the substrate, there is a problem that a wiring connecting the semiconductor light emitting elements to each other is disconnected. In addition, in this case, a problem also occurs in terms of a manufacturing cost, an assembly speed, and a light emitting efficiency.

### [Summary]

### [Technical Problem]

Embodiments aim to provide a semiconductor light emitting element, a display device including the semiconductor light emitting element, and a method for manufacturing the display device for solving the above-described problems.

Embodiments aim to improve an upper structure of a semiconductor light emitting element.

Embodiments aim to provide a curvature to an upper edge of a semiconductor light emitting element.

Embodiments aim to stably deposit a wiring in a display device including a plurality of semiconductor light emitting elements even when vertical levels of the semiconductor light emitting elements are different from each other.

Technical problems to be solved in the embodiments are not limited to those mentioned above, and other technical problems not mentioned are able to be considered by a person having ordinary skill in the art from various embodiments to be described below.

### [Technical Solutions]

According to embodiments, provided is a semiconductor light emitting element including a first conductive electrode layer, a first conductive semiconductor layer electrically connected to the first conductive electrode layer and positioned on the first conductive electrode layer, an active layer positioned on the first conductive semiconductor layer, a second conductive semiconductor layer positioned on the active layer, wherein the second conductive semiconductor layer includes a upper surface, a connecting surface formed adjacent to the upper surface at a first angle relative to the upper surface, and a side surface formed adjacent to the connecting surface at a second angle relative to the upper surface, and a second conductive electrode layer electrically connected to the second conductive semiconductor layer and positioned on at least a portion of a upper surface of the second conductive semiconductor layer.

According to embodiments, the first angle and the second angle may be greater than 90 degrees and smaller than 180 degrees.

According to embodiments, the connecting surface may include n surfaces (wherein the n is an integer equal to or greater than 1), and each of the n surfaces may be formed to have an inclination greater than 90 degrees and smaller than 180 degrees relative to each other.

According to embodiments, at least a portion of the connecting surface may be formed as a curved surface.

According to embodiments, a vertical length of the connecting surface may be equal to or smaller than a vertical length of the second conductive semiconductor layer.

According to embodiments, a vertical length of the connecting surface may be 10 to 30% of a vertical length of the semiconductor light emitting element.

According to embodiments, with respect to a direction of the upper surface, a horizontal area size of the connecting surface may be 10% to 30% of a total area size of the semiconductor light emitting element.

According to embodiments, the side surface may include an inclination so as to be connected to the connecting surface and include a first side surface which is formed on at least a portion of a side surface of the active layer and the first conductive semiconductor layer, wherein the first side surface is formed at an angle of 70 to 90 degrees with respect to ground.

According to embodiments, the side surface may include an incline so as to be connected to the first side surface and includes a second side surface which is formed on at least a portion of a side surface of the first conductive semiconductor layer, wherein the second side surface is formed at an angle of 70 to 90 degrees with respect to the ground. According to embodiments, provided is a display device including a plurality of semiconductor light emitting elements that emit light, and a wiring substrate including a wiring electrically connected to the plurality of semiconductor light emitting elements, wherein at least one of the plurality of semiconductor light emitting elements includes, a first conductive electrode layer, a first conductive semiconductor layer electrically connected to the first conductive electrode layer and positioned on the first conductive electrode layer, an active layer positioned on the first conductive semiconductor layer, a second conductive semiconductor layer positioned on the active layer, wherein the second conductive semiconductor layer includes a upper surface, a connecting surface formed adjacent to the upper surface at a first angle relative to the upper surface, and a side surface formed adjacent to the connecting surface at a second angle relative to the upper surface, a second conductive electrode layer electrically connected to the second conductive semiconductor layer and positioned on at least a portion of a upper surface of the second conductive semiconductor layer, and a passivation layer surrounding at least a portion of the semiconductor light emitting element.

According to embodiments, the display device may further include an upper wiring connected to at least a portion of the second conductive electrode layer, at least a portion of the passivation layer may include a first corresponding area surrounding the connecting surface of the second conductive semiconductor layer, wherein the first corresponding area is formed corresponding to a shape of the surrounded connecting surface, and at least a portion of the upper wiring may include a second corresponding area formed on at least a portion of the passivation layer, wherein the second corresponding area is formed corresponding to the shape of the surrounded connecting surface.

According to embodiments, the connecting surface may include n surfaces, and each of the n surfaces may be adjacent to the others with an inclination greater than 90 degrees and smaller than 180 degrees relative to each other.

According to embodiments, the connecting surface may be a curved surface having a predetermined curvature.

According to embodiments, the semiconductor light emitting element may be a micro light emitting diode (micro LED) with a size in micrometers.

According to embodiments, provided is a method for manufacturing a display device including forming a semiconductor light emitting structure on a growing substrate and etching an upper portion of the semiconductor light emitting structure, transferring the semiconductor light emitting structure onto a transfer substrate, forming an electrode layer on the transferred semiconductor light emitting structure to form a semiconductor light emitting element, and assembling the semiconductor light emitting element on a wiring substrate.

According to embodiments, the etching of the upper portion of the semiconductor light emitting structure may include etching an edge of a upper surface of the semiconductor light emitting structure, and etching at least a portion of a side surface of the semiconductor light emitting structure.

According to embodiments, the etching of the edge of the upper surface of the semiconductor light emitting structure may include performing a first etching on at least a portion of the upper portion of the semiconductor light emitting structure at a first etching rate, and performing a second etching on the first-etched at least a portion of the upper portion of the semiconductor light emitting structure at a second etching rate.

According to embodiments, the second etching rate may be higher than the first etching rate.

According to embodiments, the etching of the at least a portion of the side surface of the semiconductor light emitting structure may include etching the second-etched at least a portion of the semiconductor light emitting structure at a third etching rate higher than the second etching rate.

### [Advantageous Effects]

The embodiments reduce the disconnection of the upper wiring in the semiconductor light emitting element.

The embodiments may maintain the uniform connection between the semiconductor light emitting elements in the semiconductor light emitting element.

The embodiments may provide the display device with the high lighting rate.

The embodiments may reduce the brightness variation of the plurality of semiconductor light emitting elements.

The embodiments may reduce the friction rate between the substrate and the semiconductor light emitting element.

The embodiments may increase the transfer speed when manufacturing the vertical semiconductor light emitting element.

Effects obtainable from the embodiments are not limited to the effects mentioned above, and other effects not mentioned are able to be clearly derived and understood by a person skilled in the art based on a detailed description below.

### [Brief Description of the Drawings]

The accompanying drawings, which are included as part of the detailed description to aid in understanding the embodiments, provide various embodiments and, together with the detailed description, illustrate technical features of the various embodiments.
FIG. 1 is a conceptual diagram illustrating an embodiment of a display device using a semiconductor light emitting element according to the present disclosure.
FIG. 2 is a partially enlarged diagram showing a part A shown in FIG. 1.
FIGS. 3A and 3B are cross-sectional diagrams taken along the cutting lines B-B and C-C in FIG. 2.
FIG. 4 is a conceptual diagram illustrating the flip-chip type semiconductor light emitting element of FIGS. 3A and 3B.
FIGS. 5A to 5C are conceptual diagrams illustrating various examples of color implementation with respect to a flip-chip type semiconductor light emitting element.
FIG. 6 shows cross-sectional views of a method of fabricating a display device using a semiconductor light emitting element according to the present disclosure.
FIG. 7 is a perspective diagram of a display device using a semiconductor light emitting element according to another embodiment of the present disclosure.
FIG. 8 is a cross-sectional diagram taken along a cutting line D-D shown in FIG. 8.
FIG. 9 is a conceptual diagram showing a vertical type semiconductor light emitting element shown in FIG. 8.
FIG. 10 is a diagram schematically illustrating a method for manufacturing a display device using a semiconductor light emitting element.
FIG. 11 is a diagram showing one embodiment of a method for assembling a semiconductor light emitting element onto a substrate by a self-assembly process.
FIG. 12 is an enlarged view of a portion E in FIG. 11.
FIG. 13 is a diagram illustrating a wiring process of a semiconductor light emitting element according to embodiments.
FIG. 14 is a diagram schematically illustrating a semiconductor light emitting element according to embodiments.
FIG. 15 is a schematic diagram illustrating a semiconductor light emitting element according to embodiments.
FIG. 16 is a diagram schematically illustrating an upper portion of a semiconductor light emitting element according to embodiments. FIG. 17 is a diagram illustrating a wiring process of a display device according to embodiments.
FIG. 18 is a photograph illustrating a wiring connected to a semiconductor light emitting element according to embodiments.
FIG. 19 is a flowchart of a method for manufacturing a display device according to embodiments.
FIG. 20 is a flowchart illustrating an example of s101 in FIG. 19.
FIG. 21 is a flowchart illustrating an example of s203 in FIG. 20.
FIG. 22 is a diagram schematically illustrating a semiconductor light emitting structure based on each step in FIG. 21.
FIG. 23 is a cross-sectional view of a display device according to embodiments in a front direction.
FIG. 24 is a cross-sectional view of a display device according to embodiments in a front direction.

### [Best Mode]

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

The display device described herein is a concept including all display devices that display information with a unit pixel or a set of unit pixels. Therefore, the display device may be applied not only to finished products but also to parts. For example, a panel corresponding to a part of a digital TV also independently corresponds to the display device in the present specification. The finished products include a mobile phone, a smartphone, a laptop, a digital broadcasting terminal, a personal digital assistant (PDA), a portable multimedia player (PMP), a navigation system, a slate PC, a tablet, an Ultrabook, a digital TV, a desktop computer, and the like.

However, it will be readily apparent to those skilled in the art that the configuration according to the embodiments described herein is applicable even to a new product that will be developed later as a display device.

In addition, the semiconductor light emitting element mentioned in this specification is a concept including an LED, a micro LED, and the like, and may be used interchangeably therewith.

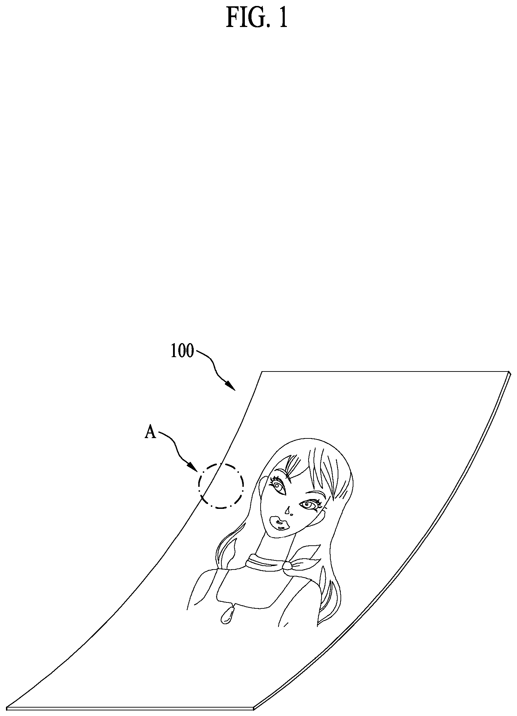

FIG. 1 is a conceptual view illustrating an embodiment of a display device using a semiconductor light emitting element according to the present disclosure.

As shown in FIG. 1, information processed by a controller (not shown) of a display device 100 may be displayed using a flexible display.

The flexible display may include, for example, a display that can be warped, bent, twisted, folded, or rolled by external force.

Furthermore, the flexible display may be, for example, a display manufactured on a thin and flexible substrate that can be warped, bent, folded, or rolled like paper while maintaining the display characteristics of a conventional flat panel display.

When the flexible display remains in an unbent state (e.g., a state having an infinite radius of curvature) (hereinafter referred to as a first state), the display area of the flexible display forms a flat surface. When the display in the first sate is changed to a bent state (e.g., a state having a finite radius of curvature) (hereinafter referred to as a second state) by external force, the display area may be a curved surface. As shown in FIG. 1, the information displayed in the second state may be visual information output on a curved surface. Such visual information may be implemented by independently controlling the light emission of sub-pixels arranged in a matrix form. The unit pixel may mean, for example, a minimum unit for implementing one color.

The unit pixel of the flexible display may be implemented by a semiconductor light emitting element. In the present disclosure, a light emitting diode (LED) is exemplified as a type of the semiconductor light emitting element configured to convert electric current into light. The LED may be formed in a small size, and may thus serve as a unit pixel even in the second state.

Hereinafter, a flexible display implemented using the LED will be described in more detail with reference to the drawings.

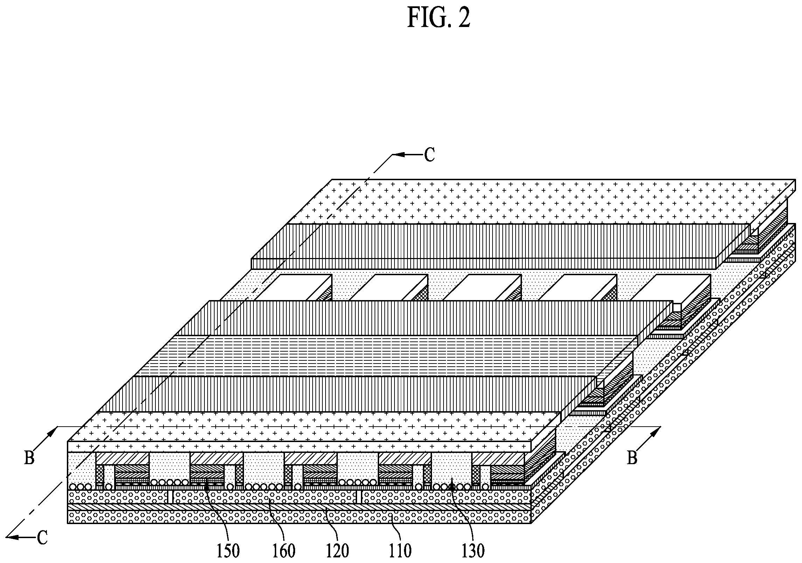

FIG. 2 is a partially enlarged view showing part A of FIG. 1.

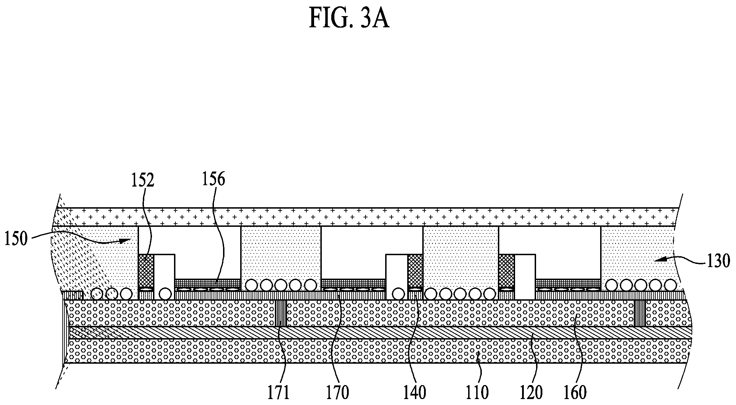

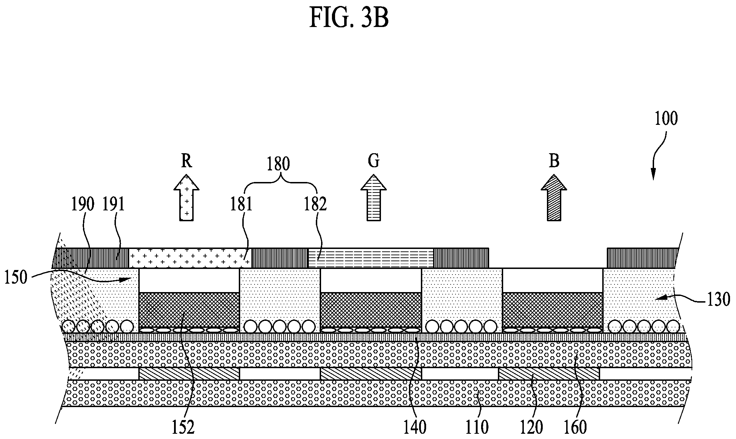

FIGS. 3A and 3B are cross-sectional views taken along lines B-B and C-C in FIG. 2.

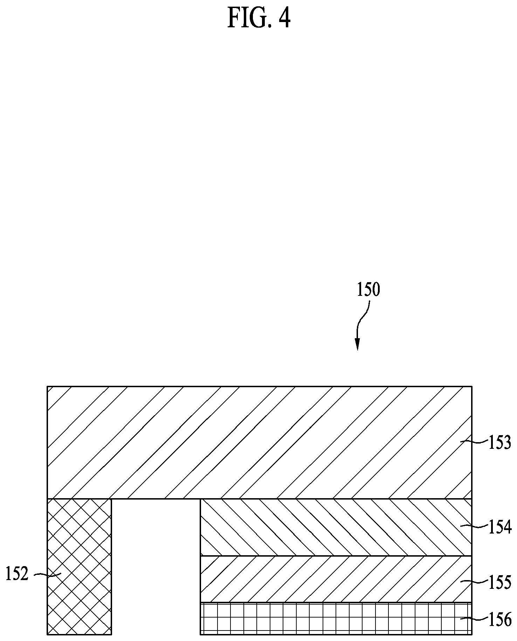

FIG. 4 is a conceptual view illustrating the flip-chip type semiconductor light emitting element of FIGS. 3A and 3B.

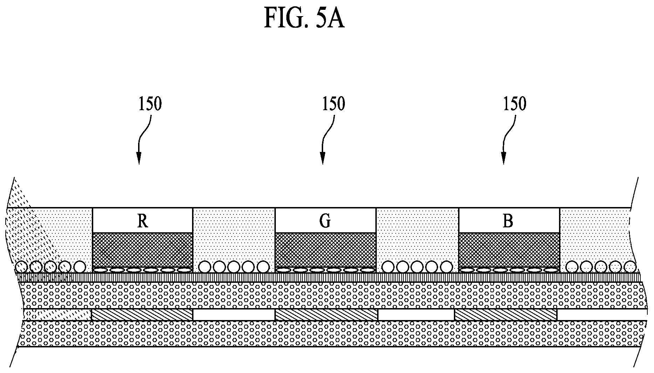

FIGS. 5A to 5C are conceptual views illustrating various examples of implementation of colors in relation to a flip-chip type semiconductor light emitting element.

As shown in FIGS. 2, 3A and 3B, the display device 100 using a passive matrix (PM) type semiconductor light emitting element is exemplified as the display device 100 using a semiconductor light emitting element. However, the examples described below are also applicable to an active matrix (AM) type semiconductor light emitting element.

The display device 100 shown in FIG. 1 may include a substrate 110, a first electrode 120, a conductive adhesive layer 130, a second electrode 140, and at least one semiconductor light emitting element 150, as shown in FIG. 2.

The substrate 110 may be a flexible substrate. For example, to implement a flexible display device, the substrate 110 may include glass or polyimide (PI). Any insulative and flexible material such as polyethylene naphthalate (PEN) or polyethylene terephthalate (PET) may be employed. In addition, the substrate 110 may be formed of either a transparent material or an opaque material.

The substrate 110 may be a wiring substrate on which the first electrode 120 is disposed. Thus, the first electrode 120 may be positioned on the substrate 110.

As shown in FIG. 3A, an insulating layer 160 may be disposed on the substrate 110 on which the first electrode 120 is positioned, and an auxiliary electrode 170 may be positioned on the insulating layer 160. In this case, a stack in which the insulating layer 160 is laminated on the substrate 110 may be a single wiring substrate. More specifically, the insulating layer 160 may be formed of an insulative and flexible material such as PI, PET, or PEN, and may be integrated with the substrate 110 to form a single substrate.

The auxiliary electrode 170, which is an electrode that electrically connects the first electrode 120 and the semiconductor light emitting element 150, is positioned on the insulating layer 160, and is disposed to correspond to the position of the first electrode 120. For example, the auxiliary electrode 170 may have a dot shape and may be electrically connected to the first electrode 120 by an electrode hole 171 formed through the insulating layer 160. The electrode hole 171 may be formed by filling a via hole with a conductive material.

As shown in FIGS. 2 or 3A, a conductive adhesive layer 130 may be formed on one surface of the insulating layer 160, but embodiments of the present disclosure are not limited thereto. For example, a layer performing a specific function may be formed between the insulating layer 160 and the conductive adhesive layer 130, or the conductive adhesive layer 130 may be disposed on the substrate 110 without the insulating layer 160. In a structure in which the conductive adhesive layer 130 is disposed on the substrate 110, the conductive adhesive layer 130 may serve as an insulating layer.

The conductive adhesive layer 130 may be a layer having adhesiveness and conductivity. For this purpose, a material having conductivity and a material having adhesiveness may be mixed in the conductive adhesive layer 130. In addition, the conductive adhesive layer 130 may have ductility, thereby providing making the display device flexible.

As an example, the conductive adhesive layer 130 may be an anisotropic conductive film (ACF), an anisotropic conductive paste, a solution containing conductive particles, or the like. The conductive adhesive layer 130 may be configured as a layer that allows electrical interconnection in the direction of the Z-axis extending through the thickness, but is electrically insulative in the horizontal X-Y direction. Accordingly, the conductive adhesive layer 130 may be referred to as a Z-axis conductive layer (hereinafter, referred to simply as a "conductive adhesive layer").

The ACF is a film in which an anisotropic conductive medium is mixed with an insulating base member. When the ACF is subjected to heat and pressure, only a specific portion thereof becomes conductive by the anisotropic conductive medium. Hereinafter, it will be described that heat and pressure are applied to the ACF. However, another method may be used to make the ACF partially conductive. The other method may be, for example, application of only one of the heat and pressure or UV curing.

In addition, the anisotropic conductive medium may be, for example, conductive balls or conductive particles. For example, the ACF may be a film in which conductive balls are mixed with an insulating base member. Thus, when heat and pressure are applied to the ACF, only a specific portion of the ACF is allowed to be conductive by the conductive balls. The ACF may contain a plurality of particles formed by coating the core of a conductive material with an insulating film made of a polymer material. In this case, as the insulating film is destroyed in a portion to which heat and pressure are applied, the portion is made to be conductive by the core. At this time, the cores may be deformed to form layers that contact each other in the thickness direction of the film. As a more specific example, heat and pressure are applied to the whole ACF, and an electrical connection in the Z-axis direction is partially formed by the height difference of a counterpart adhered by the ACF.

As another example, the ACF may contain a plurality of particles formed by coating an insulating core with a conductive material. In this case, as the conductive material is deformed (pressed) in a portion to which heat and pressure are applied, the portion is made to be conductive in the thickness direction of the film. As another example, the conductive material may be disposed through the insulating base member in the Z-axis direction to provide conductivity in the thickness direction of the film. In this case, the conductive material may have a pointed end.

The ACF may be a fixed array ACF in which conductive balls are inserted into one surface of the insulating base member. More specifically, the insulating base member may be formed of an adhesive material, and the conductive balls may be intensively disposed on the bottom portion of the insulating base member. Thus, when the base member is subjected to heat and pressure, it may be deformed together with the conductive balls, exhibiting conductivity in the vertical direction.

However, the present disclosure is not necessarily limited thereto, and the ACF may be formed by randomly mixing conductive balls in the insulating base member, or may be composed of a plurality of layers with conductive balls arranged on one of the layers (as a double- ACF).

The anisotropic conductive paste may be a combination of a paste and conductive balls, and may be a paste in which conductive balls are mixed with an insulating and adhesive base material. Also, the solution containing conductive particles may be a solution containing any conductive particles or nanoparticles.

Referring back to FIG. 3A, the second electrode 140 is positioned on the insulating layer 160 and spaced apart from the auxiliary electrode 170. That is, the conductive adhesive layer 130 is disposed on the insulating layer 160 having the auxiliary electrode 170 and the second electrode 140 positioned thereon.

After the conductive adhesive layer 130 is formed with the auxiliary electrode 170 and the second electrode 140 positioned on the insulating layer 160, the semiconductor light emitting element 150 is connected thereto in a flip-chip form by applying heat and pressure. Thereby, the semiconductor light emitting element 150 is electrically connected to the first electrode 120 and the second electrode 140.

Referring to FIG. 4, the semiconductor light emitting element may be a flip chip-type light emitting device.

For example, the semiconductor light emitting element may include a p-type electrode 156, a p-type semiconductor layer 155 on which the p-type electrode 156 is formed, an active layer 154 formed on the p-type semiconductor layer 155, an n-type semiconductor layer 153 formed on the active layer 154, and an n-type electrode 152 disposed on the n-type semiconductor layer 153 and horizontally spaced apart from the p-type electrode 156. In this case, the p-type electrode 156 may be electrically connected to the auxiliary electrode 170, which is shown in FIGS. 3A and 3B, by the conductive adhesive layer 130, and the n-type electrode 152 may be electrically connected to the second electrode 140.

Referring back to FIGS. 2, 3A and 3B, the auxiliary electrode 170 may be elongated in one direction. Thus, one auxiliary electrode may be electrically connected to the plurality of semiconductor light emitting elements 150. For example, p-type electrodes of semiconductor light emitting elements on left and right sides of an auxiliary electrode may be electrically connected to one auxiliary electrode.

More specifically, the semiconductor light emitting element 150 may be press-fitted into the conductive adhesive layer 130 by heat and pressure. Thereby, only the portions of the semiconductor light emitting element 150 between the p-type electrode 156 and the auxiliary electrode 170 and between the n-type electrode 152 and the second electrode 140 may exhibit conductivity, and the other portions of the semiconductor light emitting element 150 do not exhibit conductivity as they are not press-fitted. In this way, the conductive adhesive layer 130 interconnects and electrically connects the semiconductor light emitting element 150 and the auxiliary electrode 170 and interconnects and electrically connects the semiconductor light emitting element 150 and the second electrode 140.

The plurality of semiconductor light emitting elements 150 may constitute a light emitting device array, and a phosphor conversion layer 180 may be formed on the light emitting device array.

The light emitting device array may include a plurality of semiconductor light emitting elements having different luminance values. Each semiconductor light emitting element 150 may constitute a unit pixel and may be electrically connected to the first electrode 120. For example, a plurality of first electrodes 120 may be provided, and the semiconductor light emitting elements may be arranged in, for example, several columns. The semiconductor light emitting elements in each column may be electrically connected to any one of the plurality of first electrodes.

In addition, since the semiconductor light emitting elements are connected in a flip-chip form, semiconductor light emitting elements grown on a transparent dielectric substrate may be used. The semiconductor light emitting elements may be, for example, nitride semiconductor light emitting elements. Since the semiconductor light emitting element 150 has excellent luminance, it may constitute an individual unit pixel even when it has a small size.

As shown in FIG. 3, a partition wall 190 may be formed between the semiconductor light emitting elements 150. In this case, the partition wall 190 may serve to separate individual unit pixels from each other, and may be integrated with the conductive adhesive layer 130. For example, by inserting the semiconductor light emitting element 150 into the ACF, the base member of the ACF may form the partition wall.

In addition, when the base member of the ACF is black, the partition wall 190 may have reflectance and increase contrast even without a separate black insulator.

As another example, a reflective partition wall may be separately provided as the partition wall 190. In this case, the partition wall 190 may include a black or white insulator depending on the purpose of the display device. When a partition wall including a white insulator is used, reflectivity may be increased. When a partition wall including a black insulator is used, it may have reflectance and increase contrast.

The phosphor conversion layer 180 may be positioned on the outer surface of the semiconductor light emitting element 150. For example, the semiconductor light emitting element 150 may be a blue semiconductor light emitting element that emits blue (B) light, and the phosphor conversion layer 180 may function to convert the blue (B) light into a color of a unit pixel. The phosphor conversion layer 180 may be a red phosphor 181 or a green phosphor 182 constituting an individual pixel.

That is, the red phosphor 181 capable of converting blue light into red (R) light may be laminated on a blue semiconductor light emitting element at a position of a unit pixel of red color, and the green phosphor 182 capable of converting blue light into green (G) light may be laminated on the blue semiconductor light emitting element at a position of a unit pixel of green color. Only the blue semiconductor light emitting element may be used alone in the portion constituting the unit pixel of blue color. In this case, unit pixels of red (R), green (G), and blue (B) may constitute one pixel. More specifically, a phosphor of one color may be laminated along each line of the first electrode 120. Accordingly, one line on the first electrode 120 may be an electrode for controlling one color. That is, red (R), green (G), and blue (B) may be sequentially disposed along the second electrode 140, thereby implementing a unit pixel.

However, embodiments of the present disclosure are not limited thereto. Unit pixels of red (R), green (G), and blue (B) may be implemented by combining the semiconductor light emitting element 150 and the quantum dot (QD) rather than using the phosphor.

Also, a black matrix 191 may be disposed between the phosphor conversion layers to improve contrast. That is, the black matrix 191 may improve contrast of light and darkness.

However, embodiments of the present disclosure are not limited thereto, and anther structure may be applied to implement blue, red, and green colors.

Referring to FIG. 5A, each semiconductor light emitting element may be implemented as a high-power light emitting device emitting light of various colors including blue by using gallium nitride (GaN) as a main material and adding indium (In) and/or aluminum (Al).

In this case, each semiconductor light emitting element may be a red, green, or blue semiconductor light emitting element to form a unit pixel (sub-pixel). For example, red, green, and blue semiconductor light emitting elements R, G, and B may be alternately disposed, and unit pixels of red, green, and blue may constitute one pixel by the red, green and blue semiconductor light emitting elements. Thereby, a full-color display may be implemented.

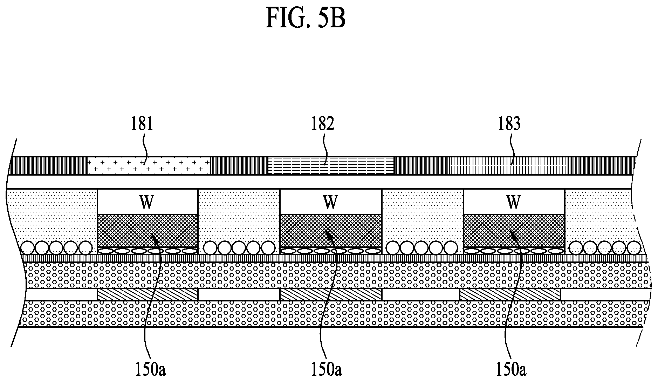

Referring to FIG. 5B, the semiconductor light emitting element 150a may include a white light emitting device W having a yellow phosphor conversion layer, which is provided for each device. In this case, in order to form a unit pixel, a red phosphor conversion layer 181, a green phosphor conversion layer 182, and a blue phosphor conversion layer 183 may be disposed on the white light emitting device W. In addition, a unit pixel may be formed using a color filter repeating red, green, and blue on the white light emitting device W.

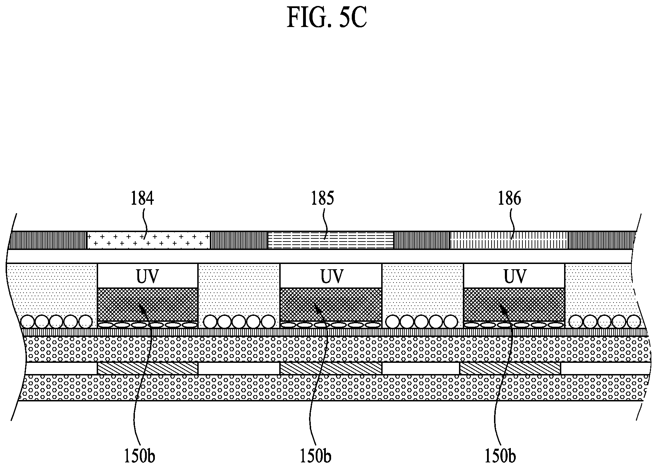

Referring to FIG. 5C, a red phosphor conversion layer 184, a green phosphor conversion layer 185, and a blue phosphor conversion layer 186 may be provided on a ultraviolet light emitting device. Not only visible light but also ultraviolet (UV) light may be used in the entire region of the semiconductor light emitting element. In an embodiment, UV may be used as an excitation source of the upper phosphor in the semiconductor light emitting element.

Referring back to this example, the semiconductor light emitting element is positioned on the conductive adhesive layer to constitute a unit pixel in the display device. Since the semiconductor light emitting element has excellent luminance, individual unit pixels may be configured despite even when the semiconductor light emitting element has a small size.

Regarding the size of such an individual semiconductor light emitting element, the length of each side of the device may be, for example, 80 µm or less, and the device may have a rectangular or square shape. When the semiconductor light emitting element has a rectangular shape, the size thereof may be less than or equal to 20 µm x 80 µm.

In addition, even when a square semiconductor light emitting element having a side length of 10 µm is used as a unit pixel, sufficient brightness to form a display device may be obtained.

Therefore, for example, in case of a rectangular pixel having a unit pixel size of 600 *µ*m x 300 *µ*m (i.e., one side by the other side), a distance of a semiconductor light emitting element becomes sufficiently long relatively.

Thus, in this case, it is able to implement a flexible display device having high image quality over HD image quality.

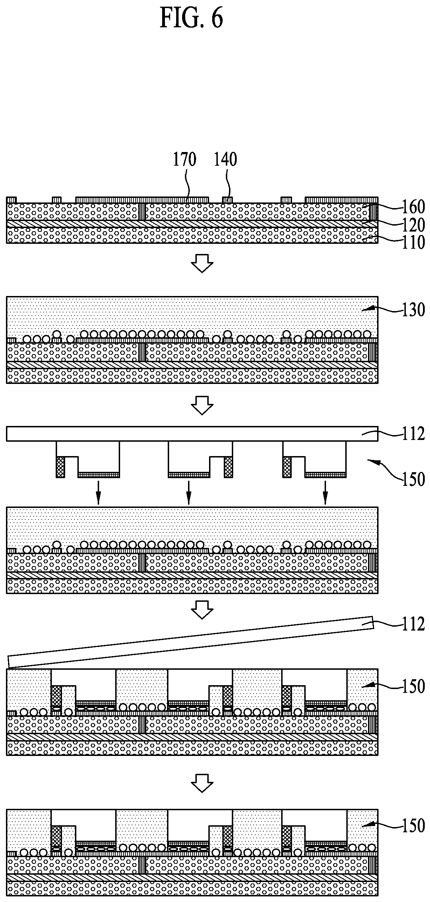

The above-described display device using the semiconductor light emitting element may be prepared by a new fabricating method. Such a fabricating method will be described with reference to FIG. 6 as follows.

FIG. 6 shows cross-sectional views of a method of fabricating a display device using a semiconductor light emitting element according to the present disclosure.

Referring to FIG. 6, first of all, a conductive adhesive layer 130 is formed on an insulating layer 160 located between an auxiliary electrode 170 and a second electrode 140. The insulating layer 160 is tacked on a wiring substrate 110. On the wiring substrate 110, a first electrode 120, the auxiliary electrode 170 and the second electrode 140 are disposed. In this case, the first electrode 120 and the second electrode 140 may be disposed in mutually orthogonal directions, respectively. In order to implement a flexible display device, the wiring substrate 110 and the insulating layer 160 may include glass or polyimide (PI) each.

For example, the conductive adhesive layer 130 may be implemented by an anisotropic conductive film. To this end, an anisotropic conductive film may be coated on the substrate on which the insulating layer 160 is located.

Subsequently, a temporary substrate 112, on which a plurality of semiconductor light emitting elements 150 configuring individual pixels are located to correspond to locations of the auxiliary electrode 170 and the second electrodes 140, is disposed in a manner that the semiconductor light emitting element 150 confronts the auxiliary electrode 170 and the second electrode 140.

In this regard, the temporary 112 substrate 112 is a growing substrate for growing the semiconductor light emitting element 150 and may include a sapphire or silicon substrate.

The semiconductor light emitting element is configured to have a space and size for configuring a display device when formed in unit of wafer, thereby being effectively used for the display device.

Subsequently, the wiring substrate 110 and the temporary substrate 112 are thermally compressed together. By the thermocompression, the wiring substrate 110 and the temporary substrate 112 are bonded together. Owing to the property of an anisotropic conductive film having conductivity by thermocompression, only a portion among the semiconductor light emitting element 150, the auxiliary electrode 170 and the second electrode 140 has conductivity, via which the electrodes and the semiconductor light emitting element 150 may be connected electrically. In this case, the semiconductor light emitting element 150 is inserted into the anisotropic conductive film, by which a partition may be formed between the semiconductor light emitting elements 150.

Then the temporary substrate 112 is removed. For example, the temporary substrate 112 may be removed using Laser Lift-Off (LLO) or Chemical Lift-Off (CLO).

Finally, by removing the temporary substrate 112, the semiconductor light emitting elements 150 exposed externally. If necessary, the wiring substrate 110 to which the semiconductor light emitting elements 150 are coupled may be coated with silicon oxide (SiOx) or the like to form a transparent insulating layer (not shown).

In addition, a step of forming a phosphor layer on one side of the semiconductor light emitting element 150 may be further included. For example, the semiconductor light emitting element 150 may include a blue semiconductor light emitting element emitting Blue (B) light, and a red or green phosphor for converting the blue (B) light into a color of a unit pixel may form a layer on one side of the blue semiconductor light emitting element.

The above-described fabricating method or structure of the display device using the semiconductor light emitting element may be modified into various forms. For example, the above-described display device may employ a vertical semiconductor light emitting element.

Furthermore, a modification or embodiment described in the following may use the same or similar reference numbers for the same or similar configurations of the former example and the former description may apply thereto.

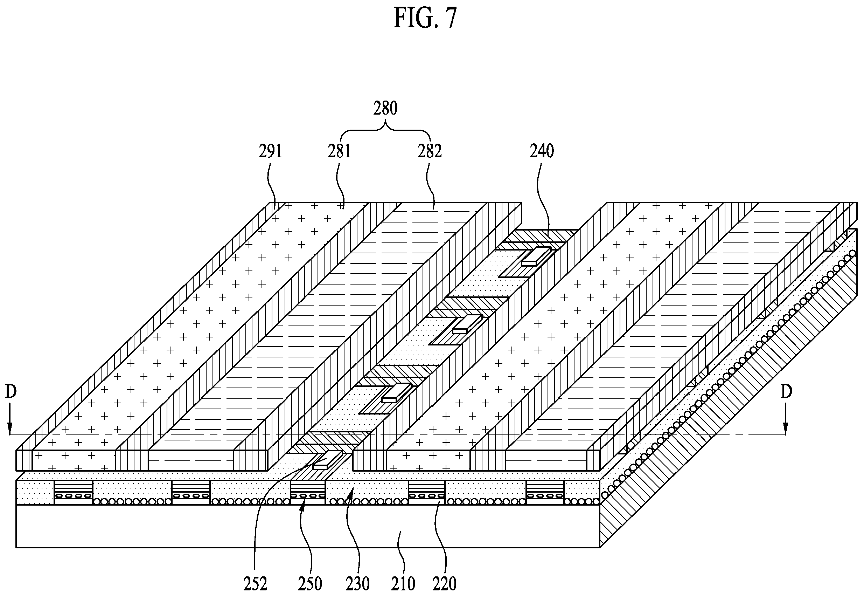

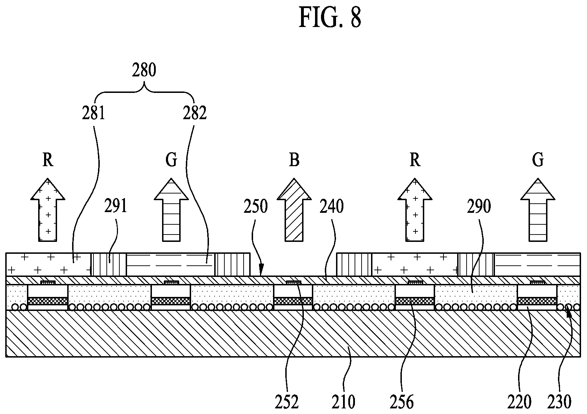

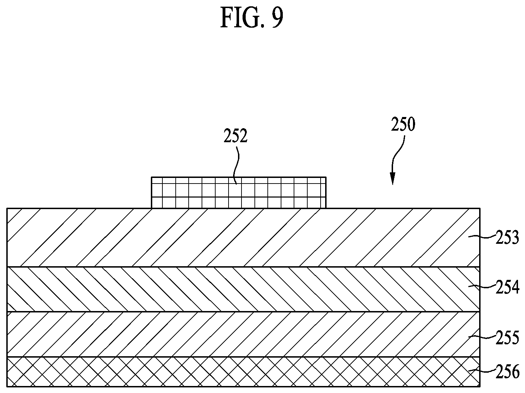

FIG. 7 is a perspective diagram of a display device using a semiconductor light emitting element according to another embodiment of the present disclosure, FIG. 8 is a cross-sectional diagram taken along a cutting line D-D shown in FIG. 8, and FIG. 9 is a conceptual diagram showing a vertical type semiconductor light emitting element shown in FIG. 8.

Referring to the present drawings, a display device may employ a vertical semiconductor light emitting device of a Passive Matrix (PM) type.

The display device includes a substrate 210, a first electrode 220, a conductive adhesive layer 230, a second electrode 240 and at least one semiconductor light emitting element 250.

The substrate 210 is a wiring substrate on which the first electrode 220 is disposed and may contain polyimide (PI) to implement a flexible display device. Besides, the substrate 210 may use any substance that is insulating and flexible.

The first electrode 210 is located on the substrate 210 and may be formed as a bar type electrode that is long in one direction. The first electrode 220 may be configured to play a role as a data electrode.

The conductive adhesive layer 230 is formed on the substrate 210 where the first electrode 220 is located. Like a display device to which a light emitting device of a flip chip type is applied, the conductive adhesive layer 230 may include one of an Anisotropic Conductive Film (ACF), an anisotropic conductive paste, a conductive particle contained solution and the like. Yet, in the present embodiment, a case of implementing the conductive adhesive layer 230 with the anisotropic conductive film is exemplified.

After the conductive adhesive layer has been placed in the state that the first electrode 220 is located on the substrate 210, if the semiconductor light emitting element 250 is connected by applying heat and pressure thereto, the semiconductor light emitting element 250 is electrically connected to the first electrode 220. In doing so, the semiconductor light emitting element 250 is preferably disposed to be located on the first electrode 220.

If heat and pressure is applied to an anisotropic conductive film, as described above, since the anisotropic conductive film has conductivity partially in a thickness direction, the electrical connection is established. Therefore, the anisotropic conductive film is partitioned into a conductive portion and a non-conductive portion.

Furthermore, since the anisotropic conductive film contains an adhesive component, the conductive adhesive layer 230 implements mechanical coupling between the semiconductor light emitting element 250 and the first electrode 220 as well as mechanical connection.

Thus, the semiconductor light emitting element 250 is located on the conductive adhesive layer 230, via which an individual pixel is configured in the display device. As the semiconductor light emitting element 250 has excellent luminance, an individual unit pixel may be configured in small size as well. Regarding a size of the individual semiconductor light emitting element 250, a length of one side may be equal to or smaller than 80 *µ*m for example and the individual semiconductor light emitting element 250 may include a rectangular or square element. For example, the rectangular element may have a size equal to or smaller than 20 *µ*m X 80 *µ*m.

The semiconductor light emitting element 250 may have a vertical structure.

Among the vertical type semiconductor light emitting elements, a plurality of second electrodes 240 respectively and electrically connected to the vertical type semiconductor light emitting elements 250 are located in a manner of being disposed in a direction crossing with a length direction of the first electrode 220.

Referring to FIG. 9, the vertical type semiconductor light emitting element 250 includes a p-type electrode 256, a p-type semiconductor layer 255 formed on the p-type electrode 256, an active layer 254 formed on the p-type semiconductor layer 255, an n-type semiconductor layer 253 formed on the active layer 254, and an n-type electrode 252 formed on then-type semiconductor layer 253. In this case, the p-type electrode 256 located on a bottom side may be electrically connected to the first electrode 220 by the conductive adhesive layer 230, and the n-type electrode 252 located on a top side may be electrically connected to a second electrode 240 described later. Since such a vertical type semiconductor light emitting element 250 can dispose the electrodes at top and bottom, it is considerably advantageous in reducing a chip size.

Referring to FIG. 8 again, a phosphor layer 280 may formed on one side of the semiconductor light emitting element 250. For example, the semiconductor light emitting element 250 may include a blue semiconductor light emitting element 251 emitting blue (B) light, and a phosphor layer 280 for converting the blue (B) light into a color of a unit pixel may be provided. In this regard, the phosphor layer 280 may include a red phosphor 281 and a green phosphor 282 configuring an individual pixel.

Namely, at a location of configuring a red unit pixel, the red phosphor 281 capable of converting blue light into red (R) light may be stacked on a blue semiconductor light emitting element. At a location of configuring a green unit pixel, the green phosphor 282 capable of converting blue light into green (G) light may be stacked on the blue semiconductor light emitting element. Moreover, the blue semiconductor light emitting element may be singly usable for a portion that configures a blue unit pixel. In this case, the unit pixels of red (R), green (G) and blue (B) may configure a single pixel.

Yet, the present disclosure is non-limited by the above description. In a display device to which a light emitting element of a flip chip type is applied, as described above, a different structure for implementing blue, red and green may be applicable.

Regarding the present embodiment again, the second electrode 240 is located between the semiconductor light emitting elements 250 and connected to the semiconductor light emitting elements electrically. For example, the semiconductor light emitting elements 250 are disposed in a plurality of columns, and the second electrode 240 may be located between the columns of the semiconductor light emitting elements 250.

Since a distance between the semiconductor light emitting elements 250 configuring the individual pixel is sufficiently long, the second electrode 240 may be located between the semiconductor light emitting elements 250.

The second electrode 240 may be formed as an electrode of a bar type that is long in one direction and disposed in a direction vertical to the first electrode.

In addition, the second electrode 240 and the semiconductor light emitting element 250 may be electrically connected to each other by a connecting electrode protruding from the second electrode 240. Particularly, the connecting electrode may include a n-type electrode of the semiconductor light emitting element 250. For example, the n-type electrode is formed as an ohmic electrode for ohmic contact, and the second electrode covers at least one portion of the ohmic electrode by printing or deposition. Thus, the second electrode 240 and the n-type electrode of the semiconductor light emitting element 250 may be electrically connected to each other.

Referring to FIG. 8 again, the second electrode 240 may be located on the conductive adhesive layer 230. In some cases, a transparent insulating layer (not shown) containing silicon oxide (SiOx) and the like may be formed on the substrate 210 having the semiconductor light emitting element 250 formed thereon. If the second electrode 240 is placed after the transparent insulating layer has been formed, the second electrode 240 is located on the transparent insulating layer. Alternatively, the second electrode 240 may be formed in a manner of being spaced apart from the conductive adhesive layer 230 or the transparent insulating layer.

If a transparent electrode of Indium Tin Oxide (ITO) or the like is sued to place the second electrode 240 on the semiconductor light emitting element 250, there is a problem that ITO substance has poor adhesiveness to an n-type semiconductor layer. Therefore, according to the present disclosure, as the second electrode 240 is placed between the semiconductor light emitting elements 250, it is advantageous in that a transparent electrode of ITO is not used. Thus, light extraction efficiency can be improved using a conductive substance having good adhesiveness to an n-type semiconductor layer as a horizontal electrode without restriction on transparent substance selection.

Referring to FIG. 8 again, a partition 290 may be located between the semiconductor light emitting elements 250. Namely, in order to isolate the semiconductor light emitting element 250 configuring the individual pixel, the partition 290 may be disposed between the vertical type semiconductor light emitting elements 250. In this case, the partition 290 may play a role in separating the individual unit pixels from each other and be formed with the conductive adhesive layer 230 as an integral part. For example, by inserting the semiconductor light emitting element 250 in an anisotropic conductive film, a base member of the anisotropic conductive film may form the partition.

In addition, if the base member of the anisotropic conductive film is black, the partition 290 may have reflective property as well as a contrast ratio may be increased, without a separate block insulator.

For another example, a reflective partition may be separately provided as the partition 190. The partition 290 may include a black or white insulator depending on the purpose of the display device.

In case that the second electrode 240 is located right onto the conductive adhesive layer 230 between the semiconductor light emitting elements 250, the partition 290 may be located between the vertical type semiconductor light emitting element 250 and the second electrode 240 each. Therefore, an individual unit pixel may be configured using the semiconductor light emitting element 250. Since a distance between the semiconductor light emitting elements 250 is sufficiently long, the second electrode 240 can be placed between the semiconductor light emitting elements 250. And, it may bring an effect of implementing a flexible display device having HD image quality.

In addition, as shown in FIG. 8, a black matrix 291 may be disposed between the respective phosphors for the contrast ratio improvement. Namely, the black matrix 291 may improve the contrast between light and shade.

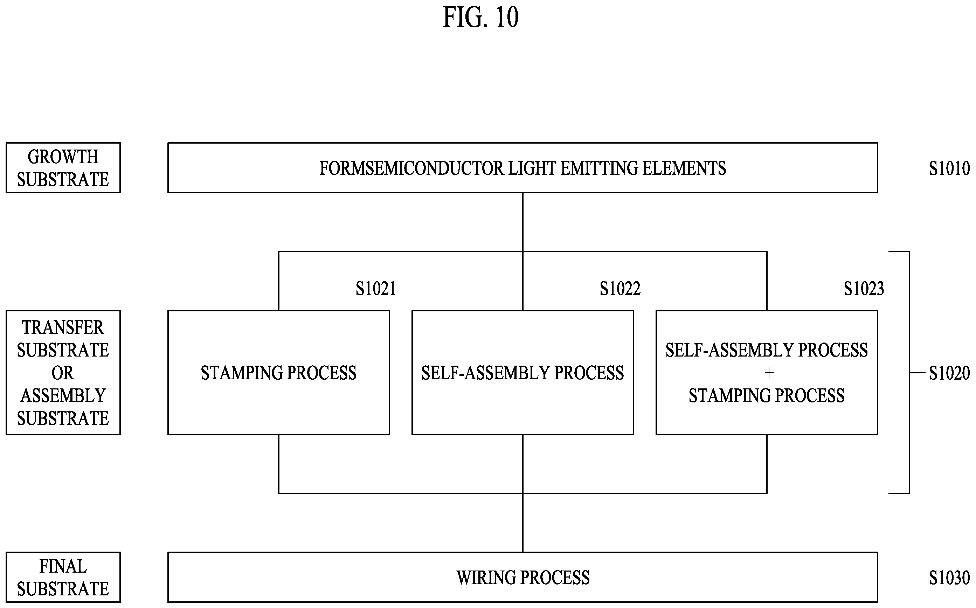

FIG. 10 is a diagram schematically illustrating a method for manufacturing a display device using a semiconductor light emitting element.

First, the semiconductor light emitting elements are formed on the growing substrate (S1010). The semiconductor light emitting elements may include a first conductivity type semiconductor layer, an active layer, and a second conductivity type semiconductor layer. In addition, a first conductivity type electrode formed on the first conductivity type semiconductor layer and a second conductivity type electrode formed on the second conductivity type semiconductor layer may be further included.

The semiconductor light emitting elements may be a horizontal type semiconductor light emitting element or the vertical type semiconductor light emitting element. However, in the case of the vertical type semiconductor light emitting element, because the first conductivity type electrode and the second conductivity type electrode face each other, a process of separating the semiconductor light emitting element from the growing substrate and forming a conductivity type electrode in one direction is added in a subsequent process. In addition, as will be described later, the semiconductor light emitting element may include a magnetic layer for a self-assembly process.

In order to utilize the semiconductor light emitting elements in the display device, in general, three types of semiconductor light emitting elements that emit light of colors corresponding to red (R), green (G), and blue (B) are required. Because semiconductor light emitting elements emitting light of one color are formed on one growing substrate, a separate substrate is required for the display device that implements individual unit pixels using the three types of semiconductor light emitting elements. Therefore, individual semiconductor light emitting elements must be separated from the growing substrate and assembled or transferred onto a final substrate. The final substrate is a substrate on which a process of forming a wiring electrode for applying a voltage to the semiconductor light emitting element such that the semiconductor light emitting element may emit light is performed.

Therefore, the semiconductor light emitting elements emitting the light of the respective colors may be transferred back to the final substrate after moving to the transfer substrate or the assembly substrate (S1020). In some cases, when performing the wiring process directly on the transfer substrate or the assembly substrate, the transfer substrate or the assembly substrate serves as the final substrate.

The method (S1020) for disposing the semiconductor light emitting element on the transfer substrate or the assembly substrate may be roughly divided into three types.

A first type is a method (S1021) for moving the semiconductor light emitting element from the growing substrate to the transfer substrate by the stamp process. The stamp process refers to a process of separating the semiconductor light emitting element from the growing substrate through a protrusion using a substrate that is made of a flexible material and having the adhesive protrusion. By adjusting a spacing and an arrangement of the protrusions, the semiconductor light emitting element of the growing substrate may be selectively separated.

A second type is a method (S1022) for assembling the semiconductor light emitting element onto the assembly substrate using the self-assembly process. For the self-assembly process, the semiconductor light emitting element must exist independently by being separated from the growing substrate, so that the semiconductor light emitting elements are separated from the growing substrate through a laser lift-off (LLO) process or the like as much as the required number of semiconductor light emitting elements. Thereafter, the semiconductor light emitting elements are dispersed in a fluid and assembled onto the assembly substrate using an electromagnetic field.

The self-assembly process may simultaneously assemble the semiconductor light emitting elements that respectively implement the R, G, and B colors on one assembly substrate, or assemble the semiconductor light emitting element of the individual color through an individual assembly substrate.

A third type is a method (S1023) for mixing the stamp process and the self-assembly process. First, the semiconductor light emitting elements are placed on the assembly substrate through the self-assembly process, and then the semiconductor light emitting elements are moved to the final substrate through the stamp process. In the case of the assembly substrate, because it is difficult to implement the assembly substrate in a large area due to a location of the assembly substrate during the self-assembly process, a contact with the fluid, an influence of the electromagnetic fields, or the like, a process of transferring the semiconductor light emitting elements to the final substrate of a large area after assembling the semiconductor light emitting elements using an assembly substrate of an appropriate area may be performed several times with the stamp process.

When a plurality of semiconductor light emitting elements constituting the individual unit pixel are placed on the final substrate, the wiring process for electrically connecting the semiconductor light emitting elements to each other is performed (S1030).

The wiring electrode formed through the wiring process electrically connects the semiconductor light emitting elements assembled or transferred onto the substrate to the substrate. In addition, a transistor for driving an active matrix may be previously formed beneath the substrate. Accordingly, the wiring electrode may be electrically connected to the transistor.

In one example, innumerable semiconductor light emitting elements are required for a large-area display device, so that the self-assembly process is preferable. In order to further improve an assembly speed, among the self-assembly processes, it may be preferred that the semiconductor light emitting elements of the respective colors are simultaneously assembled onto one assembly substrate. In addition, in order for the semiconductor light emitting elements of the respective colors to be assembled at predetermined specific positions on the assembly substrate, it may be required for the semiconductor light emitting elements to have a mutually exclusive structure.

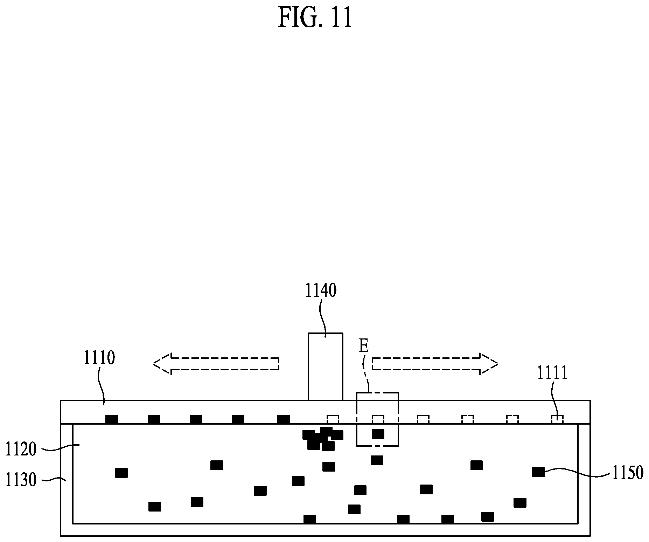

FIG. 11 is a diagram showing one embodiment of a method for assembling a semiconductor light emitting element onto a substrate by a self-assembly process.

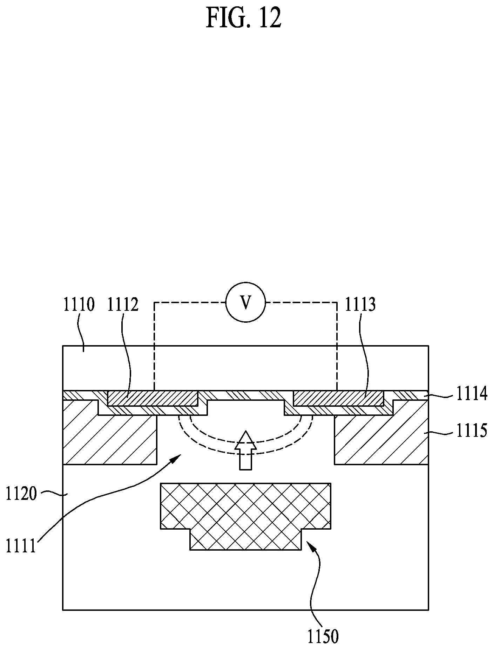

FIG. 12 is an enlarged view of a portion E in FIG. 11.

Referring to FIGS. 11 and 12, a semiconductor light emitting element 1150 may be input into a chamber 1130 filled with a fluid 1120.

Thereafter, the assembly substrate 1110 may be disposed on the chamber 1130. According to an embodiment, the assembly substrate 1110 may be introduced into the chamber 1130. In this regard, a direction in which the assembly substrate 1110 is introduced is a direction in which an assembly groove 1111 of the assembly substrate 1110 faces the fluid 1120.

A pair of electrodes 1112 and 1113 corresponding to each semiconductor light emitting element 1150 to be assembled may be formed on the assembly substrate 1110. The electrodes 1112 and 1113 may be implemented as transparent electrodes (ITO) or may be implemented using other common materials. The electrodes 1112 and 1113 correspond to assembly electrodes that stably fix the semiconductor light emitting element 1150 in contact with the assembly electrodes 1112 and 1113 by generating an electric field as a voltage is applied thereto.

Specifically, an alternating voltage may be applied to the electrodes 1112 and 1113, and the semiconductor light emitting element 1150 floating around the electrodes 1112 and 1113 may have a polarity by dielectric polarization. In addition, the dielectrically polarized semiconductor light emitting element may be moved in a specific direction or fixed by a nonuniform electric field formed around the electrodes 1112 and 1113. This is referred to as dielectrophoresis (DEP). In a self-assembly process of the present disclosure, the semiconductor light emitting element 1150 may be stably fixed into the assembly groove 1111 using the dielectrophoresis. The intensity of the dielectrophoresis (DEP force) is proportional to the strength of the electric field and varies depending on the degree of dielectric polarization within the semiconductor light emitting element.

In addition, a spacing between the assembly electrodes 1112 and 1113 may be, for example, smaller than a width of the semiconductor light emitting element 1150 and a diameter of the assembly groove 1111, so that an assembly position of the semiconductor light emitting element 1150 using the electric field may be more precisely fixed.

In addition, an insulating layer 1114 may be formed on the assembly electrodes 1112 and 1113 to protect the electrodes 1112 and 1113 from the fluid 1120 and to prevent leakage of current flowing through the assembly electrodes 1112 and 1113. For example, the insulating layer 1114 may be composed of a single layer or multiple layers of an inorganic insulator such as silica or alumina or an organic insulator. In addition, the insulating layer 1114 may have a minimum thickness for preventing damage to the assembly electrodes 1112 and 1113 when assembling the semiconductor light emitting element 1150 and may have a maximum thickness for stably assembling the semiconductor light emitting element 1150.
[1] A partition wall 1115 may be formed on the insulating layer 1114. A partial region of the partition wall 1115 may be located above the assembly electrodes 1112 and 1113, and the remaining region thereof may be located above the assembly substrate 1110.
[2] For example, when manufacturing the assembly substrate 1110, as a portion of the partition wall formed on the entire insulating layer 1114 is removed, the assembly groove 1111 in which each of the semiconductor light emitting elements 1150 is coupled to the assembly substrate 1110 may be defined.
[3] As shown in FIG. 12, the assembly groove 1111 into which the semiconductor light emitting element 1150 is coupled may be defined in the assembly substrate 1110 and a surface in which the assembly groove 1111 is defined may be in contact with the fluid 1120. The assembly groove 1111 may guide the accurate assembly position of the semiconductor light emitting element 1150.

In addition, the partition wall 1115 may be formed to have a certain inclination from an opening of the assembly groove 1111 toward a bottom surface. For example, by adjusting the inclination of the partition wall 1115, the assembly groove 1111 may have the opening and the bottom surface and an area of the opening may be larger than an area of the bottom surface. Accordingly, the semiconductor light emitting element 1150 may be assembled at an accurate position on the bottom surface of the assembly groove 1111.

The assembly groove 1111 may have a shape and a size corresponding to those of the semiconductor light emitting element 1150 to be assembled. Accordingly, it is possible to prevent other semiconductor light emitting elements from being assembled into the assembly groove 1111 or to prevent a plurality of semiconductor light emitting elements from being assembled into the assembly groove 1111.

In addition, a depth of the assembly groove 1111 may be smaller than a vertical height of the semiconductor light emitting element 1150. Therefore, the semiconductor light emitting element 1150 may have a structure protruding to a portion between the portions of the partition walls 1115, and may easily come into contact with a protrusion of the transfer substrate during a transfer process that may occur after the assembly.

In addition, as shown in FIG. 12, after the assembly substrate 1110 is disposed, an assembly apparatus 1140 containing a magnetic body may move along the assembly substrate 1110. The assembly apparatus 1140 may move in contact with the assembly substrate 1110 in order to maximize a region of a magnetic field into the fluid 1120. For example, the assembly apparatus 1140 may contain a plurality of magnetic bodies or may contain a magnetic body of a size corresponding to that of the assembly substrate 1110. In this case, a moving distance of the assembly apparatus 1140 may be limited to be in a predetermined range.

The semiconductor light emitting element 1150 in the chamber 1130 may move toward the assembly apparatus 1140 by the magnetic field generated by the assembly apparatus 1140.

While moving toward the assembly apparatus 1140, the semiconductor light emitting element 1150 may enter the assembly groove 1111 and come into contact with the assembly substrate 1110, as shown in FIG. 12.

In addition, the semiconductor light emitting element 1150 may include a magnetic layer therein such that the self-assembly process may be performed.

The semiconductor light emitting element 1150 in contact with the assembly substrate 1110 may be prevented from deviating by the movement of the assembly device 1140 because of the electric field generated by the assembly electrodes 1112 and 1113 of the assembly substrate 1110.

Accordingly, the plurality of semiconductor light emitting elements 1150 are simultaneously assembled to the assembly substrate 1110 in the self-assembly method using the electromagnetic field shown in FIGS. 11 and 12.

A display device 2000 according to embodiments is manufactured by assembling the semiconductor light emitting element with the substrate as described in FIGS. 10 to 12, for example. To reduce a cost and improve mass productivity when manufacturing the display device, miniaturization of the semiconductor light emitting element included in the display device is required. To this end, a semiconductor light emitting element 2100 according to embodiments is, for example, a micro light emitting diode (micro LED) in size units of micrometers. Such a semiconductor light emitting element is formed as a vertical semiconductor light emitting element as described in FIGS. 1 to 9, for example.

In one example, in a case of horizontal semiconductor light emitting element, a manufacturing process is relatively easy because all of conductive electrodes respectively connected to conductive semiconductor layers are formed on one surface of the element. However, a quantity of the horizontal semiconductor light emitting elements that may be manufactured on the same area of the growing substrate is smaller than a quantity of the vertical semiconductor light emitting elements. Therefore, in a display device that uses millions or more of semiconductor light emitting elements, it is advantageous in terms of the manufacturing cost to use the vertical semiconductor light emitting elements.

Therefore, hereinafter, the semiconductor light emitting element described in FIGS. 1 to 9, for example, the vertical semiconductor light emitting element will be described.

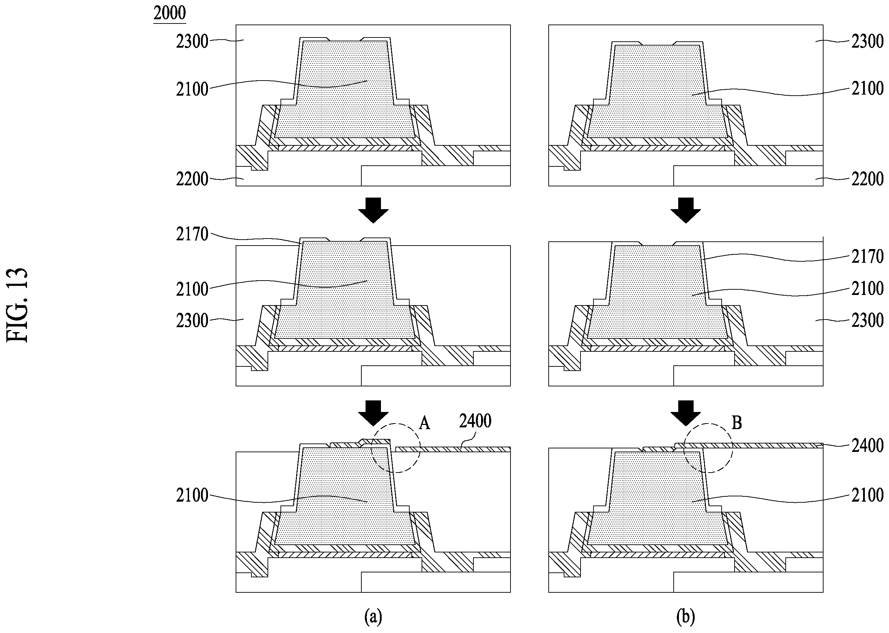

FIG. 13 is a diagram illustrating a wiring process of a semiconductor light emitting element according to embodiments.

FIG. 13 illustrates assembly of the semiconductor light emitting element manufactured according to the method described in FIGS. 1 to 9 on the substrate and connection of wiring.

In FIG. 13, 2000 represents a display device (e.g., the display device described in FIGS. 1 to 12). Further, in FIG. 13, 2100 represents a semiconductor light emitting element (e.g., the semiconductor light emitting element 150 and the vertical semiconductor light emitting element 250 described in FIGS. 1 to 9, and the semiconductor light emitting element 1150 described in FIGS. 10 to 12).

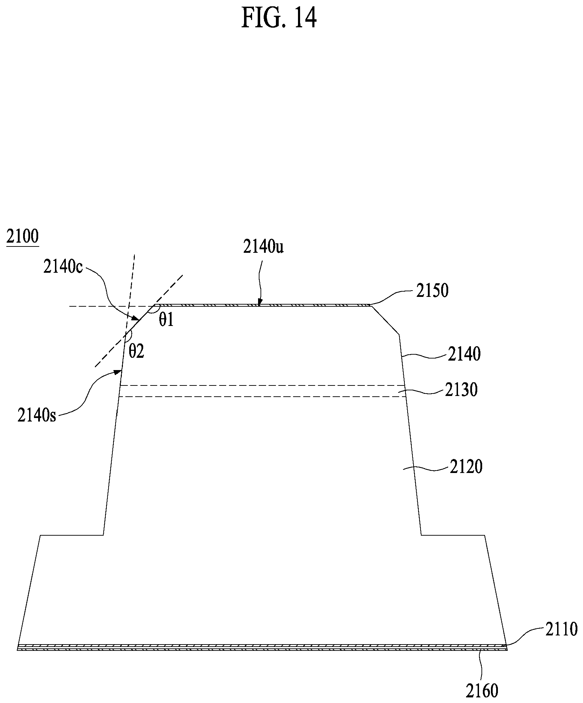

The semiconductor light emitting element 2100 is, for example, the vertical semiconductor light emitting element. The semiconductor light emitting element 2100 electrically connects a first conductive electrode layer 2110 (see FIG. 14) with a second conductive electrode layer 2150 (see FIG. 14) to emit light. To this end, the display device 2000 performs a wiring 2300 process on the second conductive electrode layer 2150 located at a top of the semiconductor light emitting element 2100.

The display device 2000 includes an upper wiring 2400 to be coupled with the semiconductor light emitting element 2100 and electrically connected to the semiconductor light emitting element 2100 so that the semiconductor light emitting element 2100 may light up. The upper wiring 2400 may be electrically connected to a conductive electrode layer located at one end of the semiconductor light emitting element 2100.

In one example, as a size of the semiconductor light emitting element 2100 decreases, it is difficult to connect the first conductive electrode layer 2110 with the second conductive electrode layer 2150. In addition, in the semiconductor light emitting elements 2100, RGB semiconductor light emitting elements may have different vertical levels depending on a process difference between blue (B), green (G), and red (R) semiconductor light emitting elements. In addition, in the semiconductor light emitting elements 2100, the plurality of semiconductor light emitting elements may have different heights because of a difference in a stacked thickness of each layer.

(a) of FIG. 13 illustrates a case in which the semiconductor light emitting element 2100 has a relatively high vertical level. In addition, (b) of FIG. 13 illustrates a case in which the semiconductor light emitting element 2100 has a relatively low vertical level.

As illustrated in FIG. 13, the semiconductor light emitting element 2100 is disposed on a wiring substrate 2200. The display device 2000 includes an organic film 2300 coated between the semiconductor light emitting elements 2100.

To connect the upper wiring 2400 to the semiconductor light emitting element 2100, an upper portion of the display device 2000 is etched. That is, an upper portion of the semiconductor light emitting element 2100 and an upper portion of the organic film 2300 are ashed.

In this regard, when the vertical level of the semiconductor light emitting element 2100 is relatively high as in (a) of FIG. 13, a passivation layer 2170 that surrounds at least a portion of an outer surface of the semiconductor light emitting element 2100 is more exposed. The passivation layer 2170 is formed higher than the organic film layer 2300. On the other hand, when the vertical level of the semiconductor light emitting element 2100 is relatively low as in (b) of FIG. 13, the passivation layer 2170 of the semiconductor light emitting element 2100 is less exposed. The passivation layer 2170 is formed at an equal or similar vertical level as the organic film layer 2300. That is, depending on the vertical level difference of the semiconductor light emitting elements 2100, the display device 2000 is formed with a different height difference between the passivation layer 2170 and the organic film layer 2300 after the etching process.

The display device 2100 includes the upper wiring 2400 deposited on top of the semiconductor light emitting element 2100. The semiconductor light emitting elements 2100 are electrically connected to each other via the upper wiring 2400 and emit light.

In this regard, when the vertical level of the semiconductor light emitting element 2100 is relatively high as in (a) of FIG. 13, a step is formed between the upper portion of the semiconductor light emitting element 2100 and the organic film layer 2300. In this case, as indicated by A in (a) of FIG. 13, there is a problem that the upper wiring 2400 deposited on top of the semiconductor light emitting element 2100 is disconnected. Alternatively, there is a problem that the upper wiring 2400 is vulnerable to short circuit. On the other hand, when the vertical level of the semiconductor light emitting element 2100 is relatively low as in (b) of FIG. 13, there is no step or a very small step is formed between the upper portion of the semiconductor light emitting element 2100 and the organic film layer 2300. In this case, as indicated by B in (b) of FIG. 13, the upper wiring 2400 deposited on top of the semiconductor light emitting element 2100 is not disconnected.

As described above, the display device 2000 may, will, or will not have the disconnection of the upper wiring 2400 depending on the vertical level difference of the plurality of semiconductor light emitting elements 2100. In other words, the display device 2000 may have problems such as partial non-lighting or weak lighting of the semiconductor light emitting elements. In addition, in this case, the display device 2000 may have problems such as uneven brightness when turned on and great brightness variation.

Therefore, hereinafter, a method for miniaturizing the semiconductor light emitting element 2100 while reducing the disconnection problem of the wiring connected to the semiconductor light emitting element 2100 will be described in detail.

FIG. 14 is a diagram schematically illustrating a semiconductor light emitting element according to embodiments.

The semiconductor light emitting element 2100 according to embodiments is, for example, the vertical semiconductor light emitting element. In addition, the semiconductor light emitting element 2100 is, for example, a circular type light emitting element, and for example, a concentric type light emitting element. However, the shape of the semiconductor light emitting element 2100 is not limited thereto.

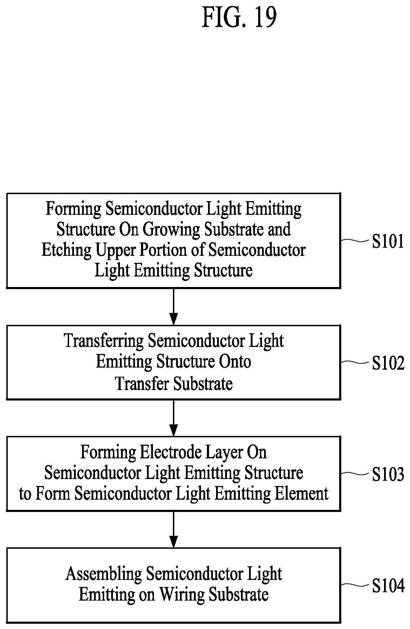

The semiconductor light emitting element 2100 includes the first conductive electrode layer 2110, a first conductive semiconductor layer 2120, an active layer 2130, a second conductive semiconductor layer 2140, and the second conductive electrode layer 2150. In addition, the semiconductor light emitting element 2100 further includes a conductive bonding layer 2160. The semiconductor light emitting element 2100 may further include the passivation layer 2170 (see FIG. 19), but in FIG. 14, the passivation layer 2170 is omitted for convenience of illustration.

The first conductive electrode layer 2110 includes an electrical and/or magnetic material. The first conductive electrode layer 2110 is, for example, an n-type metal electrode layer.

The first conductive semiconductor layer 2120 is electrically connected to the first conductive electrode layer 2110. The first conductive semiconductor layer 2120 is positioned on the first conductive electrode layer 2110. That is, the first conductive electrode layer 2110 is deposited on at least a portion of the first conductive semiconductor layer 2120. For example, the first conductive semiconductor layer 2120 is an n-type semiconductor layer. For example, the first conductive semiconductor layer 2120 is n-GaN.

The active layer 2130 generates light.

The second conductive semiconductor layer 2140 is positioned on the active layer 2130. For example, the second conductive semiconductor layer 2140 is a p-type semiconductor layer. For example, the second conductive semiconductor layer 2140 is p-GaN.

The second conductive electrode layer 2150 is electrically connected to the second conductive semiconductor layer 2140. The second conductive electrode layer 2150 is located on at least a portion of a upper surface of the second conductive semiconductor layer 2140. The second conductive electrode layer 2150 is, for example, a p-type electrode layer. For example, the second conductive electrode layer 2150 includes a transparent material. For example, the second conductive electrode layer 2150 includes ITO and FTO. Accordingly, the semiconductor light emitting element 2100 allows light generated from the active layer 2130 to transmit through the second conductive semiconductor layer 2140 and/or the second conductive electrode layer 2150 and be emitted to the outside.

The conductive bonding layer 2160 is connected to the first conductive electrode layer 2110. The conductive bonding layer 2160 allows the semiconductor light emitting element 2100 to be connected to the wiring substrate 2200 when the semiconductor light emitting element 2100 is assembled on the wiring substrate 2200. The conductive bonding layer 2160 is, for example, an n-type junction metal layer. The conductive bonding layer 2160 includes, for example, Ti and Cr. Accordingly, the conductive bonding layer 2160 may further increase a strength of a magnetic layer included in the first conductive electrode layer 2110.

In one example, the second conductive semiconductor layer 2140 includes a upper surface 2140u, a side surface 2140s, and a connecting surface 2140c formed between the upper surface 2140 and the side surface 2140s.

The upper surface 2140u of the second conductive semiconductor layer is connected to the second conductive electrode layer 2150. The side surface 2140s of the second conductive semiconductor layer forms an outer surface of the semiconductor light emitting element 2100 excluding the passivation layer 2170.

The connecting surface 2140c of the second conductive semiconductor layer is formed at a first angle θ1 with the upper surface 2140u of the second conductive semiconductor layer. The connecting surface 2140c of the second conductive semiconductor layer is formed adjacent to the upper surface 2140u of the second conductive semiconductor layer. In addition, the connecting surface 2140c of the second conductive semiconductor layer is formed at a second angle θ2 with the side surface 2140s of the second conductive semiconductor layer. The connecting surface 2140c of the second conductive semiconductor layer is formed adjacent to the side surface 2140s of the second conductive semiconductor layer.

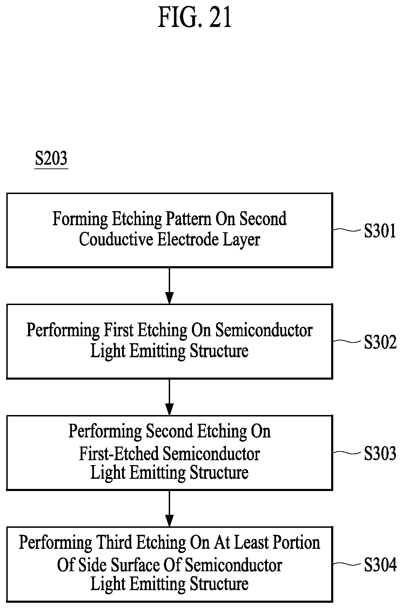

In this regard, the connecting surface 2140c of the second conductive semiconductor layer may be formed by, for example, etching at least a portion of an edge of the upper portion of the second conductive semiconductor layer 2140. This will be described in detail later in FIGS. 21 to 24.

In this regard, the first angle θ1 and the second angle θ2 are greater than 90 degrees and smaller than 180 degrees. In addition, the first angle θ1 and the second angle θ2 are greater than 90 degrees. For example, when the upper surface 2140u of the second conductive semiconductor layer is horizontal with respect to the ground, the connecting surface 2140c of the second conductive semiconductor layer is inclined downward to the ground. In addition, the side surface 2140s of the second conductive semiconductor layer is inclined more downward to the ground than the connecting surface 2140c of the second conductive semiconductor layer.

That is, in the upper portion of the second conductive semiconductor layer 2140, the edge forms a gentle slope along the upper surface 2140u, the connecting surface 2140c, and the side surface 2140s of the second conductive semiconductor layer.

In one example, even when the semiconductor light emitting element 2100 is formed of a square or polygonal type rather than the concentric type, the above-described structure may still be applied. In this case, the semiconductor light emitting element 2100 includes a connecting surface (e.g., identical or similar to 2140c) on an entirety or a portion of the edge of the upper portion of the semiconductor light emitting element 2100. For example, the upper portion of the semiconductor light emitting element 2100 may include the connecting surface only for a surface on which the upper wiring 2400 is deposited, or may include the connecting surface for all surfaces regardless of the deposition of the upper wiring 2400.

With such a structure, the semiconductor light emitting element 2100 according to embodiments provides more space on which the upper wiring 2400 is deposited when manufacturing the display device 2000.

For example, the semiconductor light emitting element 2100 provides a relatively gentle slope between the upper surface 2140u of the second conductive semiconductor layer and the side surface 2140s of the second conductive semiconductor layer via the connecting surface 2140c of the second conductive semiconductor layer. The connecting surface 2140c of the second conductive semiconductor layer increases a deposition contact area for the semiconductor light emitting element 2100 during the process of depositing the upper wiring 2400. Accordingly, the semiconductor light emitting element 2100 according to embodiments allows the upper wiring 2400 to be deposited more stably on top of the semiconductor light emitting element 2100.

Accordingly, the semiconductor light emitting element 2100 according to embodiments prevents the upper wiring of the display device 2000 including the light emitting element 2100 from being disconnected or weakened. In addition, the display device 2000 according to embodiments improves a lighting rate and a lighting uniformity when lighting up, and reduces brightness variation accordingly.

Hereinafter, examples of an upper structure of such a semiconductor light emitting element 2100 will be described in more detail.

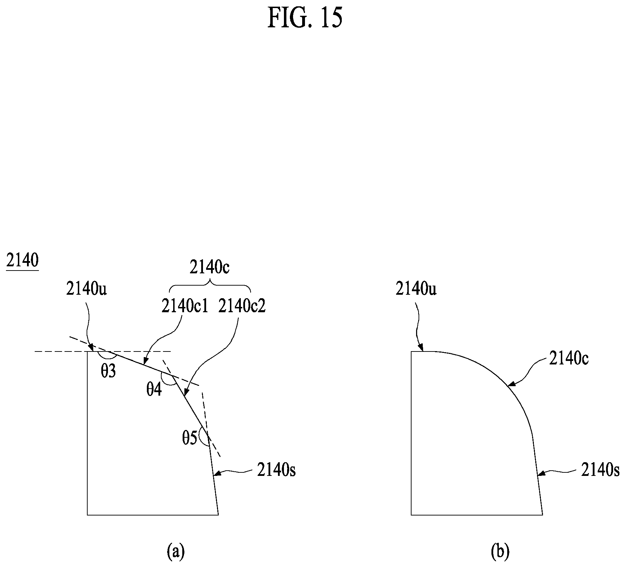

FIG. 15 is a schematic diagram illustrating a semiconductor light emitting element according to embodiments.

In FIG. 15, for convenience of illustration, only a portion of the upper surface 2140u of the second conductive semiconductor layer, a portion of the connecting surface 2140c of the second conductive semiconductor layer, and a portion of the side surface 2140s of the second conductive semiconductor layer are illustrated.

(a) in FIG. 15 illustrates an example in which the connecting surface 2140c of the second conductive semiconductor layer includes two or more surfaces.

The connecting surface 2140c of the second conductive semiconductor layer includes n surfaces (e.g., 2140c1 and 2140c2). In this regard, n is an integer equal to or greater than 1. In FIG. 15, a case in which n is an integer equal to or greater than 2 will be described. Each of the n surfaces (e.g., 2140c1 and 2140c2) is formed to have an inclination greater than 90 degrees and smaller than 180 degrees relative to each other. That is, among the n surfaces included in the connecting surface 2140c of the second conductive semiconductor layer, a surface (e.g., 2140c1) adjacent to the upper surface 2140u has an inclination greater than 90 degrees and smaller than 180 degrees relative to the upper surface 2140u of the second conductive semiconductor layer. In addition, among the n surfaces included in the connecting surface 2140c of the second conductive semiconductor layer, a surface (e.g., 2140c2) adjacent to the side surface 2140s has an inclination greater than 90 degrees and smaller than 180 degrees relative to the side surface 2140s of the second conductive semiconductor layer.

For example, as illustrated in (a) in FIG. 15, the connecting surface 2140c of the second conductive semiconductor layer includes a first connecting surface 2140c1 and a second connecting surface 2140c2.

The first connecting surface 2140c1 is formed to have a third angle θ3 relative to the upper surface 2140u of the second conductive semiconductor layer. The first connecting surface 2140c1 is formed adjacent to the upper surface 2140u of the second conductive semiconductor layer. In addition, the first connecting surface 2140c1 is formed to have a fourth angle θ4 relative to the second connecting surface 2140c2. The first connecting surface 2140c1 is formed adjacent to the second connecting surface 2140c2. The second connecting surface 2140c2 is formed to have a fifth angle θ5 relative to the side surface 2140s of the second conductive semiconductor layer. The second connecting surface 2140c2 is formed adjacent to the side surface 2140s of the second conductive semiconductor layer.

In this regard, the first connecting surface 2140c1 may be formed by, for example, etching at least a portion of the edge of the upper portion of the second conductive semiconductor layer 2140. In addition, the second connecting surface 2140c2 may be formed by, for example, etching at least a portion of the edge of the upper portion of the second conductive semiconductor layer 2140 whose edge has been at least partially etched.

For example, the second connecting surface 2140c2 is formed after the first connecting surface 2140c1 is etched first. In addition, the second connecting surface 2140c2 is etched at a higher rate than the etching for forming the first connecting surface 2140c1. In this regard, the etching rate indicates a degree of etching per hour.

As such, the connecting surface 2140 of the second conductive semiconductor layer may be formed by etching the edge of the upper portion of the second conductive semiconductor layer 2140 a plurality of times. This will be described in detail later in FIGS. 19 to 22.

As described in FIG. 14, each of the third angle θ3, the fourth angle θ4, and the fifth angle θ5 is greater than 90 degrees and smaller than 180 degrees. For example, when the upper surface 2140u of the second conductive semiconductor layer is horizontal with respect to the ground, the first connecting surface 2140c1 is inclined downward to the ground. In addition, the second connecting surface 2140c2 is inclined more downward to the ground than the first connecting surface 2140c1. In addition, the side surface 2140s of the second conductive semiconductor layer is inclined more downward to the ground than the second connecting surface 2140c2.

That is, in the upper portion of the second conductive semiconductor layer 2140, the edge forms a gentle slope along the upper surface 2140u of the second conductive semiconductor layer, the first connecting surface 2140c1, the second connecting surface 2140c2, and the side surface 2140s of the second conductive semiconductor layer.

With such a structure, the semiconductor light emitting element 2100 according to embodiments provides more space for the upper wiring 2400 to be deposited during the manufacturing of the display device 2000.

Accordingly, the semiconductor light emitting element 2100 according to embodiments prevents the upper wiring of the display device 2000 including the light emitting element 2100 from being disconnected or weakened. In addition, the display device 2000 according to embodiments improves the lighting rate and the lighting uniformity when lighting up, and reduces the brightness variation accordingly.

(b) of FIG. 15 illustrates an example in which the connecting surface 2140c of the second conductive semiconductor layer includes a curved surface.

As described in (a) of FIG. 15, the connecting surface 2140c of the second conductive semiconductor layer may include the n surfaces. In this regard, when a value of n becomes infinite, the connecting surface 2140c of the second conductive semiconductor layer may, for example, include the curved surface. That is, the semiconductor light emitting element 2100 according to embodiments includes the edge of the upper portion having a rounded shape.

With such a structure, the semiconductor light emitting element 2100 according to embodiments provides more space for the upper wiring 2400 to be deposited during the manufacturing of the display device 2000.

Accordingly, the semiconductor light emitting element 2100 according to embodiments prevents the upper wiring of the display device 2000 including the light emitting element 2100 from being disconnected or weakened. In addition, the display device 2000 according to embodiments improves the lighting rate and the lighting uniformity when lighting up, and reduces the brightness variation accordingly.

In one example, although not separately disclosed in FIGS. 14 and 15, the semiconductor light emitting element 2100 according to embodiments may include a form in which (a) and (b) of FIG. 15 are combined with each other.

Hereinafter, an area in which the connecting surface 2140c of the second conductive semiconductor layer is formed will be described.

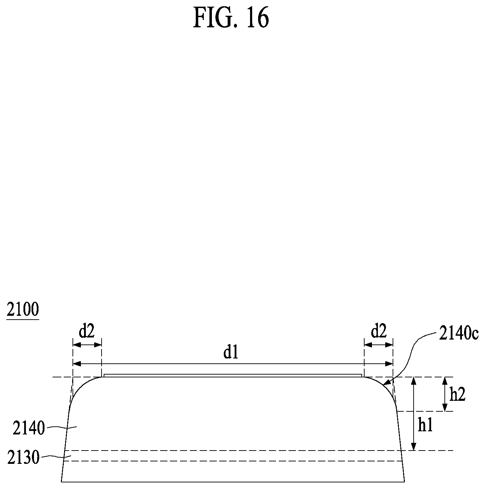

FIG. 16 is a diagram schematically illustrating an upper portion of a semiconductor light emitting element according to embodiments.

In FIG. 16, the semiconductor light emitting element 2100 including the example illustrated in (b) of FIG. 15 is illustrated.

In FIG. 16, d1 represents a horizontal length of the upper surface 2140u of the second semiconductor light emitting element as a range for a case in which the edge of the upper portion of the semiconductor light emitting element 2100 is not etched. Hereinafter, it is referred to as a horizontal length d1 of the upper surface. For example, when the semiconductor light emitting element 2100 is in the concentric shape, d1 is a diameter of the upper surface 2140u of the second semiconductor light emitting element whose upper portion is not etched.

In addition, in FIG. 16, h1 represents a height from the upper portion of the semiconductor light emitting element 2100 to an upper portion of the active layer 2130. Hereinafter, it is referred to as a vertical length h1 of the second conductive semiconductor layer 2140. In this regard, the second conductive electrode layer 2150 has a height that is small enough to be ignored when compared to heights of the second conductive semiconductor layer 2140 and the active layer 2130, and therefore is omitted in FIG. 16.

In FIG. 16, d2 represents a horizontal length of the connecting surface 2140c of the second conductive semiconductor layer. Hereinafter, it is referred to as a horizontal length d2 of the connecting surface. In addition, h2 represents a vertical length of the connecting surface 2140c of the second conductive semiconductor layer. Hereinafter, it is referred to as a vertical length h2 of the connecting surface. As illustrated in FIG. 16, the horizontal length d2 of the connecting surface is smaller than the horizontal length d1 of the upper surface. In this regard, luminance based on a ratio of the connecting surface to a total area is as shown in [Table 1] below.

**[Table 1]**

| Ratio of connecting surface to total area | 0% | 10% | 20% | 30% |
|---|---|---|---|---|
| Luminance (Cd/m²) | 956 | 1267 | 1593 | 1410 |

In this regard, results in [Table 1] were measured under conditions of 3V, measurement angle 0.1, and measurement area 2.61E-7m^2.

In one example, the total area represents an area corresponding to a horizontal area of the upper surface (an area corresponding to d1) plus a horizontal area of the connecting surface of the second conductive semiconductor layer (an area corresponding to d2x2). The connecting surface represents a horizontal area of the connecting surface of the second conductive semiconductor layer (the area corresponding to d2x2).

From [Table 1], it may be seen that the brightness of the semiconductor light emitting element 2100 increases when the connecting surface exists. In this regard, in the upper surface in the vertical direction of the semiconductor light emitting element 2100, the horizontal area of the connecting surface (the area corresponding to d2x2) is 10 to 30% of the total area. Preferably, in the upper surface in the vertical direction of the semiconductor light emitting element 2100, the horizontal area of the connecting surface (the area corresponding to d2x2) is 15 to 25% of the total area. More preferably, in the upper surface in the vertical direction of the semiconductor light emitting element 2100, the horizontal area of the connecting surface (the area corresponding to d2x2) is 20% of the total area.

With such a structure, the semiconductor light emitting element 2100 according to embodiments enables the second conductive electrode layer 2150 to be stably electrically connected to the second conductive semiconductor layer 2140. In addition, the semiconductor light emitting element 2100 according to embodiments reduces the occurrence of the disconnection of the upper wiring 2400 during the process of depositing the upper wiring 2400 during the manufacturing process of the display device 2000.

In FIG. 16, the semiconductor light emitting element 2100 is exemplified as having a wide lower portion and the narrow upper portion, but the above-described range is equally applicable even when the semiconductor light emitting element 2100 has the same length at the upper and lower portions or has a wider upper portion.

In addition, as illustrated in FIG. 16, the vertical length h2 of the connecting surface has a value that is equal to or smaller than the vertical length h1 of the second conductive semiconductor layer. That is, the connecting surface 2140c of the second conductive semiconductor layer is formed in a range in which the active layer 2130 is not etched. Accordingly, for example, the vertical length h2 of the connecting surface is 10 to 30% of a total height of the semiconductor light emitting element 2100. Preferably, the vertical length h2 of the connecting surface is, for example, 20% of the total height of the semiconductor light emitting element 2100. With such a structure, the semiconductor light emitting element 2100 according to embodiments may provide a wider area on which the upper wiring 2400 may be deposited without reducing a light emitting area of the semiconductor light emitting element 2100.

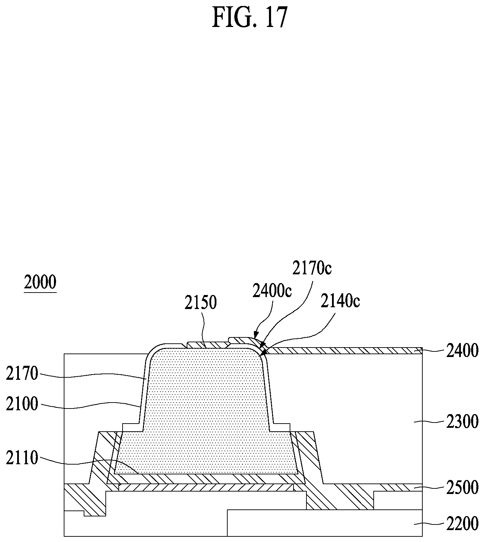

FIG. 17 is a diagram illustrating a wiring process of a display device according to embodiments.

FIG. 17 illustrates the semiconductor light emitting element 2100 including the example described in (b) in FIG. 15.

As illustrated in FIG. 17, the display device 2000 includes the plurality of semiconductor light emitting elements 2100 that emit light and the wiring substrate 2200 that includes wiring electrically connected to the plurality of semiconductor light emitting elements 2100.

The semiconductor light emitting element 2100 further includes the passivation layer 2170 formed by surrounding at least a portion of the semiconductor light emitting element 2100.

The passivation layer 2170 surrounds at least a portion of the side surface of the semiconductor light emitting element 2100. In addition, the passivation layer 2170 surrounds a portion of the upper portion of the semiconductor light emitting element 2100. The passivation layer 2170 is formed such that an entirety or a portion of the second conductive electrode 2150 is exposed such that the second conductive electrode 2150 and the upper wiring 2400 are electrically connected to each other.

With such a structure, at least a portion of the passivation layer 2170 surrounds the connecting surface 2140c of the second conductive semiconductor layer. Hereinafter, an area in which the passivation layer 2170 surrounds the connecting surface 2140c of the second conductive semiconductor layer is referred to as a first corresponding area 2170c. The first corresponding area 2170c is formed corresponding to the shape of the connecting surface 2140c of the second conductive semiconductor layer.

The passivation layer 2170 protects the semiconductor light emitting element 2100. The passivation layer 2170 is, for example, made of an insulating material. The passivation layer 2170 is, for example, made of SiO₂.

The display device 2000 includes the organic film layer 2300 between the plurality of semiconductor light emitting elements 2100. In addition, the display device 2000 further includes the upper wiring 2400 connected to the second conductive electrode 2150 and a lower wiring 2500 connected to the first conductive electrode 2110. The upper wiring 2400 is electrically connected to the second conductive electrode 2150. The lower wiring 2500 is electrically connected to the first conductive electrode 2110. With such electrical connection, the semiconductor light emitting element 2100 emits light. The organic film layer 2300 separates the upper wiring 2400 and the lower wiring 2500 from each other.

The upper wiring 2400 is formed on at least a portion of the upper portion of the semiconductor light emitting element 2100 and an upper portion of the organic film layer 2300, as illustrated in FIG. 17. Accordingly, the upper wiring 2400 is connected to at least a portion of the second conductive electrode layer 2150. In addition, the upper wiring 2400 is formed on at least a portion of the passivation layer 2170.

With such a structure, at least a portion of the upper wiring 2400 is formed on at least a portion of the first corresponding area 2170c. That is, at least a portion of the upper wiring 2400 is formed corresponding to the shape of the first corresponding area 2170c. Hereinafter, an area in which the upper wiring 2400 surrounds at least a portion of the first corresponding area 2170c is referred to as a second corresponding area 2400c. That is, the second corresponding area 2400c is formed corresponding to the shape of the connecting surface 2140c of the second conductive semiconductor layer.

In one example, the upper wiring 2400 includes a transparent material. The upper wiring 2400 includes, for example, the ITO.

As described above, the display device 2000 according to embodiments provides a structure in which light emission efficiency is improved. For example, embodiments further refract light emitted from the semiconductor light emitting element 2100 via the first corresponding area 2170c and/or the second corresponding area 2400c. That is, the display device 2000 according to embodiments further improves the light emission efficiency by further scattering the light emitted from the semiconductor light emitting element 2100 by refraction.

Hereinafter, whether the upper wiring 2400 of the display device 2000 described in FIGS. 14 to 17 is disconnected is identified via photographs obtained through experiments.

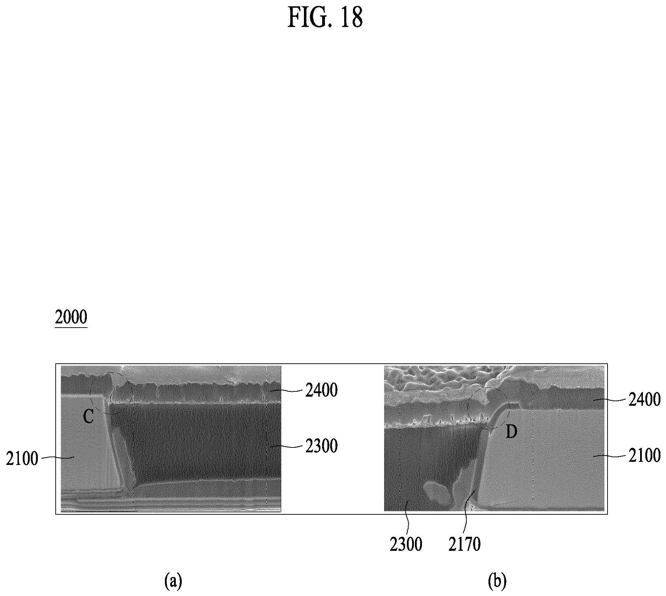

FIG. 18 is a photograph illustrating a wiring connected to a semiconductor light emitting element according to embodiments.

FIG. 18 illustrates an example in which the semiconductor light emitting element 2100 is manufactured relatively high. That is, the upper portion of the semiconductor light emitting element 2100 is positioned higher than the upper portion of the organic film layer 2300 after etching the organic film layer 2300. FIG. 18 illustrates an example in which upper wiring 2400 is deposited on top of the semiconductor light emitting element 2100 and the organic film layer 2300.

(a) of FIG. 18 is a photograph illustrating an example in which a wiring process is performed on a semiconductor light emitting element whose upper structure has not been improved. In (a) of FIG. 18, C represents the upper wiring 2400 formed on the edge of the upper portion of the semiconductor light emitting element 2100. As may be seen from C, the upper wiring 2400 includes a crack caused by a step. As such, it may be seen that in the case of the semiconductor light emitting element 2100 with the unimproved upper structure, the disconnection of the upper wiring 2400 occurs.

(b) of FIG. 18 is a photograph illustrating an example in which a wiring process is performed on the semiconductor light emitting element described in FIGS. 14 to 17 as a semiconductor light emitting element with an improved upper structure. In (b) of FIG. 18, D represents the upper wiring 2400 formed on the edge of the upper portion of the semiconductor light emitting element 2100. As may be seen from D, the disconnection of the upper wiring 2400 did not occur despite the presence of the step. As such, it may be seen that in the case of the semiconductor light emitting element 2100 with the improved upper structure, the occurrence of the disconnection of the upper wiring 2400 is reduced.

Hereinafter, a method for manufacturing the semiconductor light emitting element 2100 and the display device 2000 including the semiconductor light emitting element 2100 will be described in detail.

FIG. 19 is a flowchart of a method for manufacturing a display device according to embodiments.

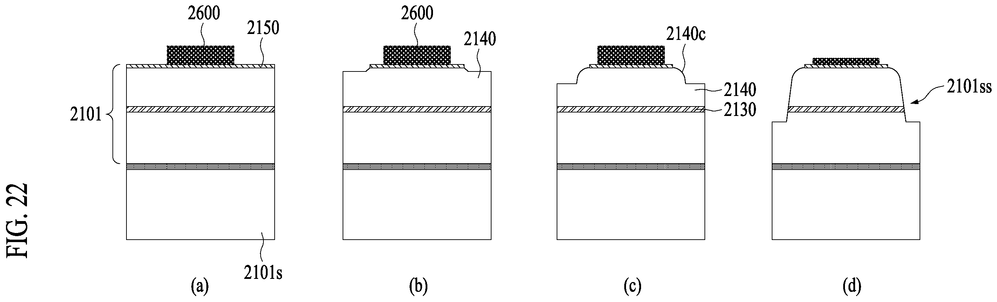

As illustrated in FIG. 19, the method for manufacturing the display device 2000 according to embodiments includes a step (s101) of forming a semiconductor light emitting structure 2101 (see FIG. 22) on a growing substrate and etching an upper portion of the semiconductor light emitting structure 2101.

The semiconductor light emitting structure 2101 includes the first conductive semiconductor layer 2120, the active layer 2130, the second conductive semiconductor layer 2140, and the second conductive electrode layer 2150. The semiconductor light emitting structure may further include the passivation layer 2170. The semiconductor light emitting structure 2101 is a structure before becoming the semiconductor light emitting element 2100.

A growing substrate 2101s (see FIG. 22) provides a space in which at least a portion of the semiconductor light emitting structure grows. The growing substrate is, for example, made of sapphire.

As illustrated in FIG. 19, the method for manufacturing the display device 2000 according to embodiments includes a step (s102) of transferring the semiconductor light emitting structure onto a transfer substrate.

For the transfer of the semiconductor light emitting structure 2101, a sacrificial layer is deposited on the semiconductor light emitting structure 2101 to surround the semiconductor light emitting structure 2101. The sacrificial layer includes, for example, Al. An organic PAC pattern is formed on the sacrificial layer. A transfer substrate is bonded onto the organic PAC pattern. After the semiconductor light emitting structure 2101 is bonded to the transfer substrate, it is separated from the growing substrate 2101s described in s101. For example, the semiconductor light emitting structure 2101 is separated from the growing substrate 2101s via laser lift off (LLO). Accordingly, a portion of the semiconductor light emitting structure 2101 that is not exposed from the growing substrate is exposed. For example, the first conductive semiconductor layer 2120 is exposed by the transfer.

As illustrated in FIG. 19, the method for manufacturing the display device 2000 according to embodiments includes a step (s103) of forming an electrode layer on the semiconductor light emitting structure to form the semiconductor light emitting element 2100.

Before forming the electrode layer, the sacrificial layer surrounding the semiconductor light emitting structure 2101 is removed. Thereafter, the electrode layer is formed on the portion of the semiconductor light emitting structure 2101 exposed by s102. For example, the first conductive electrode layer 2110 is deposited on the first conductive semiconductor layer 2120 exposed by s102. The first conductive electrode layer 2110 includes an electrical and/or magnetic material as described above. The conductive adhesive layer 2160 described in FIG. 14 may be further deposited on the first conductive electrode layer 2110. As described above, the conductive adhesive layer 2160 includes, for example, Ti, Cr, and the like. These are deposited through E-beam in the case of the magnetic layer, and through a sputter in the case of the metal. Accordingly, the semiconductor light emitting element 2100 is formed.

As shown in FIG. 19, the method for manufacturing the display device 2000 according to embodiments includes a step (s104) of assembling the semiconductor light emitting element 2100 on the wiring substrate 2200.

When the semiconductor light emitting element 2100 is formed via s103, the transfer substrate is separated from the semiconductor light emitting element 2100 to manufacture the display device 2000 by assembling the semiconductor light emitting element 2100. In this regard, the organic PAC pattern coated for the bonding with the transfer substrate is also removed.

The method for assembling the semiconductor light emitting element 2100 on the wiring substrate 2200 includes, for example, the method described in FIGS. 10 to 12. In this case, the semiconductor light emitting element 2100 separated from the transfer substrate is dispersed in fluid. In this regard, the wiring substrate 2200 includes, for example, sapphire, glass, silicon, and polyImide (PI).

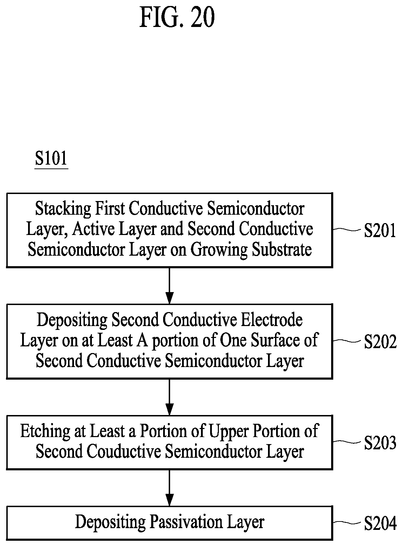

FIG. 20 is a flowchart illustrating an example of s101 in FIG. 19.

As illustrated in FIG. 20, the method for manufacturing the display device 2000 according to embodiments includes a step (s201) of stacking the first conductive semiconductor layer 2120, the active layer 2130, and the second conductive semiconductor layer 2140 on the growing substrate.

The first conductive semiconductor layer 2120, the active layer 2130, and the second conductive semiconductor layer 2140 are sequentially grown on the growing substrate. The semiconductor light emitting structure may further include a buffer layer (not shown) and/or an undoped layer to protect the semiconductor layer. For example, the semiconductor light emitting structure is, for example, grown on the growing substrate in an order of the buffer layer, the undoped layer, the first conductive semiconductor layer 2120, the active layer 2130, and the second conductive semiconductor layer 2140.

The buffer layer, the undoped layer, the first conductive semiconductor layer 2120, the active layer 2130, and/or the second conductive semiconductor layer 2140 are formed on the growing substrate by, for example, metalorganic chemical vapor deposition (MOCVD), molecular beam epitaxy (MBE), hydride vapor phase epitaxy (HVPE), and the like.

As illustrated in FIG. 20, the method for manufacturing the display device 2000 according to embodiments includes a step (s202) of depositing the second conductive electrode layer 2150 on at least a portion of one surface of the second conductive semiconductor layer 2140.

The second conductive electrode layer 2150 is deposited on the second conductive semiconductor layer 2140. The second conductive electrode layer 2150 is disposed on the second conductive semiconductor layer 2140 via a post-deposition heat treatment process.

As illustrated in FIG. 20, the method for manufacturing the display device 2000 according to embodiments includes a step (s203) of etching at least a portion of the upper portion of the second conductive semiconductor layer 2140.

The upper portion of the second conductive semiconductor layer 2140 is etched. Specifically, an edge of the upper surface of the second conductive semiconductor layer 2140 is etched. Accordingly, the upper portion of the second conductive semiconductor layer 2140 forms the structure described in FIGS. 14 to 18. In addition, at least a portion of the side surface of the second conductive semiconductor layer 2140 is etched. Accordingly, at least the portion of the side surface of the second conductive semiconductor layer 2140 forms the structure described in FIGS. 14 to 17. Accordingly, the display device 2000 according to embodiments prevents the upper wiring 2400 from being disconnected.

As illustrated in FIG. 20, the method for manufacturing the display device 2000 according to embodiments includes a step (s204) of depositing the passivation layer 2170.

According to s203, when the etching of the upper portion of the second conductive semiconductor layer 2140 is completed, an etching pattern 2600 is removed from the semiconductor light emitting structure 2101. In addition, a passivation layer 2101 is deposited while covering an entirety of the upper portion of the semiconductor light emitting structure 2101. As described above, the passivation layer 2101 is an insulating film, and is, for example, made of SiO₂. The passivation layer 2101 covering the entirety of the upper portion is partially removed to expose at least a portion of the second conductive electrode 2150.

When the passivation layer 2101 is deposited on the semiconductor light emitting structure 2101, the sacrificial layer deposition process described in s102 in FIG. 19 is performed.

In FIGS. 21 and 22 below, s203 in FIG. 20 will be described in more detail.

FIGS. 21 and 22 illustrate a method for forming the semiconductor light emitting element 2100 including the example described in (b) in FIG. 15. Therefore, for example, when forming the semiconductor light emitting element 2100 including the example described in FIG. 14, the etching may be performed only twice, unlike what is described in FIGS. 21 and 22 below. In addition, for example, when forming the semiconductor light emitting element 2100 formed of the polygonal type as in (a) in FIG. 15, the etching may be performed may be performed three times or more, unlike what is described in FIGS. 21 and 22 below.

FIG. 21 is a flowchart illustrating an example of s203 in FIG. 20.

FIG. 22 is a diagram schematically illustrating a semiconductor light emitting structure based on each step in FIG. 21.

As illustrated in FIG. 21, the method for manufacturing the display device 2000 according to embodiments includes a step (s301) of forming the etching pattern 2600 on the second conductive electrode layer 2150.

(a) in FIG. 22 illustrates the semiconductor light emitting structure 2101 formed on the growing substrate 2101s. As illustrated in (a) in FIG. 22, according to s301, the etching pattern 2600 is formed on the second conductive electrode layer 2150. The etching pattern 2600 is, for example, a photo resist (PR).

As illustrated in FIG. 21, the method for manufacturing the display device 2000 according to embodiments includes a step (s302) of performing a first etching on the semiconductor light emitting structure 2101.

As illustrated in (b) in FIG. 22, the first etching is performed on at least a portion of the upper portion of the semiconductor light emitting structure 2101. In this regard, the first etching is performed with a first etching rate.

Accordingly, the upper portion of the semiconductor light emitting structure 2101 has an upper portion shape suitable for the deposition on the display device 2000. In addition, based on the first etching, an angle for forming the connecting surface 2140c of the second conductive semiconductor layer is determined. For example, based on the first etching, a curvature suitable for forming the connecting surface 2140c of the second conductive semiconductor layer is determined.

As illustrated in FIG. 21, the method for manufacturing the display device 2000 according to embodiments includes a step (s303) of performing a second etching on the semiconductor light emitting structure 2101 on which the first etching has been performed.

As illustrated in (c) in FIG. 22, the second etching is performed on at least the portion of the upper portion of the semiconductor light emitting structure 2101 on which the first etching has been performed. Via the second etching, the connecting surface 2140c of the second conductive semiconductor layer is formed. In this regard, the second etching is performed with a second etching rate. The second etching rate is higher than the first etching rate.

The etching rate indicates an amount etched per time. The etching rate increases, for example, by increasing power of an apparatus for the etching. For example, greater power is required when performing the second etching than when performing the first etching. Alternatively, the etching rate increases, for example, by increasing a concentration of etching particles. For example, when the etching includes plasma etching, the concentration of etching particles (e.g., Cl₂) is required to be higher when performing the second etching than when performing the first etching. In one example, such etched amount may be increased by increasing an etching time. For example, the etching may be performed for a longer time when performing the second etching than when performing the first etching.

As described in FIG. 16, the second etching is performed only within the height range of the second conductive semiconductor layer 2140. That is, the second etching is not performed on the active layer 2130.

As illustrated in FIG. 21, the method for manufacturing the display device 2000 according to embodiments includes a step (s304) of performing a third etching on the semiconductor light emitting structure 2101.

As illustrated in (d) in FIG. 22, the third etching is performed on at least a portion of the side surface of the semiconductor light emitting structure 2101 on which the second etching has been performed. Via the third etching, at least a portion of the side surface 2101ss of the semiconductor light emitting structure is exposed. Accordingly, the semiconductor light emitting structure 2101 more easily performs step s104 described in FIG. 19. In this regard, the third etching is performed with a third etching rate. The third etching rate is higher than the second etching rate. Based on the third etching, the side surface 2101ss of the semiconductor light emitting structure is etched more steeply than when performing the first etching and the second etching.

When step of s304 is completed, the passivation layer 2170 is deposited while surrounding at least a portion of the side surface 2101ss of the semiconductor light emitting structure based on s204 in FIG. 20.

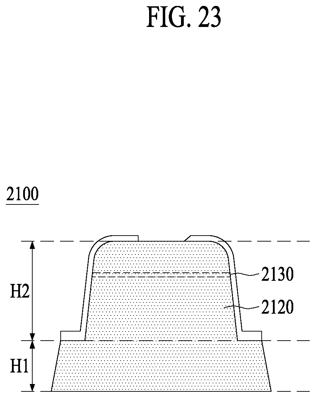

A performing degree and a form of the third etching will be described below with FIGS. 23 to 24.

FIG. 23 is a cross-sectional view of a display device according to embodiments in a front direction.

In FIG. 23, H1 represents a length of an area in which the third etching described in (d) in FIG. 22 is performed in the semiconductor light emitting element 2100. H1 is, for example, a vertical length of a first side surface that is connected to the connecting surface and forms an inclination. In this regard, the first side surface is formed, for example, on at least partial side surfaces of the active layer 2130 and the first conductive semiconductor layer 2120.

In addition, H2 in FIG. 23 represents a length of an area in which the third etching described in (d) in FIG. 22 is not performed in the semiconductor light emitting element 2100. H2 is, for example, a vertical length of a second side surface that is connected to the first side surface and forms an inclination. In this regard, the second side surface is formed on, for example, at least a partial side surface of the first conductive semiconductor layer 2120.

In this regard, when H1 does not have a sufficient value, for example, when performing the laser lift off (LLO) after bonding the semiconductor light emitting element 2100 to the substrate, there is a problem that the lower portion of the semiconductor light emitting element 2100 is damaged in the process of separating the semiconductor light emitting element 2100 from the substrate.

Alternatively, when H2 does not have a sufficient value, there is a problem that a short circuit occurs. For example, when the area having H1 includes the active layer 2130 or H2 is defined in an area above the active layer 2130, there is a problem that the first conductive semiconductor layer 2120 and/or the second conductive semiconductor layer 2140 are connected to the lower wiring 2500, resulting in the short circuit.

Therefore, the semiconductor light emitting element 2100 according to embodiments has H1 and H2 having an appropriate ratio to each other. For example, H2 is 2 to 4 times H1. Preferably, H2 is 3 times H1. In one example, H1 is equal to or greater than 650um to prevent damage. Preferably, H1 is equal to or greater than 750um to prevent the damage.

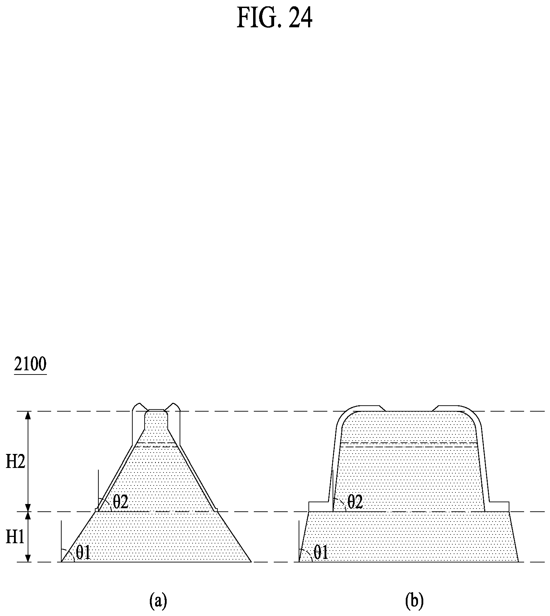

FIG. 24 is a cross-sectional view of a display device according to embodiments in a front direction.

In FIG. 24, θ1 represents a side surface angle of the semiconductor light emitting element 2100 formed in the H1 section. Further, in FIG. 24, θ2 represents a side surface angle of the semiconductor light emitting element 2100 formed in the H2 section.

θ1 is, for example, equal to or greater than 70 degrees and smaller than 90 degrees. For example, (a) in FIG. 24 illustrates a case in which θ1 is smaller than 70 degrees. In this case, as an end of the semiconductor light emitting element 2100 becomes thinner, the semiconductor light emitting element 2100 may be relatively more damaged during the LLO process compared to (b) in FIG. 24 where θ1 is equal to or greater than 70 degrees.

Alternatively, for example, θ2 is equal to or greater than 70 degrees and smaller than 90 degrees. For example, (a) in FIG. 24 illustrates a case in which θ2 is smaller than 70 degrees. In this case, as a size of the active layer 2130 decreases, a light emitting area is relatively reduced compared to that in (b) in FIG. 24 in which θ2 is equal to or greater than 70 degrees. Therefore, light efficiency may be reduced.

Therefore, the semiconductor light emitting element 2100 according to embodiments is formed such that θ1 and/or θ2 are equal to or greater than 70 degrees and smaller than 90 degrees. Accordingly, the embodiments enable the light efficiency to be high while minimizing the damage to the semiconductor light emitting element 2100.

With the above-described features, the embodiments provide the semiconductor light emitting element, the display device including the semiconductor light emitting element, and the method for manufacturing the display device with the improved light emitting efficiency. For example, the embodiments provide the semiconductor light emitting element, the display device including the semiconductor light emitting element, and the method for manufacturing the display device in which the disconnection of the upper wiring is reduced and the connection between the upper and lower lighting wirings and the semiconductor light emitting element is uniformly maintained. In addition, accordingly, the embodiments provide the semiconductor light emitting element, the display device including the semiconductor light emitting element, and the method for manufacturing the display device with the reduced brightness variation of the semiconductor light emitting element. In addition, the embodiments may reduce a friction rate between the substrate and the semiconductor light emitting element and improve a transfer speed when manufacturing the semiconductor light emitting element via the fluid, for example, by etching the edge of the upper portion. In addition, the embodiments provide the semiconductor light emitting element, the display device including the semiconductor light emitting element, and the method for manufacturing the display device having excellent uniformity because of uniform brightness.

In one example, the embodiments are applied to the semiconductor light emitting element. For example, the embodiments are applied to the vertical semiconductor light emitting element. For example, the embodiments are applied to the miniaturized semiconductor light emitting element such as the micro LED.

Although the light emitting element, the display device including the light emitting element, and the method for manufacturing the display according to the embodiments of the present disclosure have been described as specific embodiments, these are merely examples, and the present disclosure is not limited thereto, and should be interpreted as having the broadest scope according to the basic idea disclosed herein.

A person skilled in the art may combine or substitute the disclosed embodiments to implement embodiments not explicitly described herein, but such implementations also fall within the scope of the present disclosure. Furthermore, based on the present document, a person skilled in the art may readily modify or alter the disclosed embodiments, and it is evident that such modifications or alterations also fall within the scope of the present disclosure.

### [Industrial Applicability]

The light emitting element, the display device including the light emitting element, and the method for manufacturing the display device according to the embodiments have industrial applicability.

## Claims

1. A semiconductor light emitting element comprising:
a first conductive electrode layer;
a first conductive semiconductor layer electrically connected to the first conductive electrode layer and positioned on the first conductive electrode layer;
an active layer positioned on the first conductive semiconductor layer;
a second conductive semiconductor layer positioned on the active layer, wherein the second conductive semiconductor layer includes an upper surface, a connecting surface formed adjacent to the upper surface at a first angle relative to the upper surface, and a side surface formed adjacent to the connecting surface at a second angle relative to the upper surface; and
a second conductive electrode layer electrically connected to the second conductive semiconductor layer and positioned on at least a portion of the upper surface of the second conductive semiconductor layer.

2. The semiconductor light emitting element of claim 1, wherein the first angle and the second angle are greater than 90 degrees and smaller than 180 degrees.

3. The semiconductor light emitting element of claim 1, wherein the connecting surface includes n surfaces (wherein the n is an integer equal to or greater than 1), and each of the n surfaces is formed to have an inclination greater than 90 degrees and smaller than 180 degrees relative to each other.

4. The semiconductor light emitting element of claim 1, wherein at least a portion of the connecting surface is formed as a curved surface.

5. The semiconductor light emitting element of claim 1, wherein a vertical length of the connecting surface is equal to or smaller than a vertical length of the second conductive semiconductor layer.

6. The semiconductor light emitting element of claim 1, wherein a vertical length of the connecting surface is 10% to 30% of a vertical length of the semiconductor light emitting element.

7. The semiconductor light emitting element of claim 1, wherein a horizontal area size of the connecting surface is 10% to 30% of a total area size of the semiconductor light emitting element.

8. The semiconductor light emitting element of claim 1, wherein the side surface includes an inclination so as to be connected to the connecting surface and includes a first side surface which is formed on at least a portion of a side surface of the active layer and the first conductive semiconductor layer, wherein the first side surface is formed at an angle of 70 to 90 degrees with respect to ground.

9. The semiconductor light emitting element of claim 8, wherein the side surface includes an incline so as to be connected to the first side surface and includes a second side surface which is formed on at least a portion of a side surface of the first conductive semiconductor layer, wherein the second side surface is formed at an angle of 70 to 90 degrees with respect to the ground.

10. A display device comprising:
a plurality of semiconductor light emitting elements configured to emit light; and
a wiring substrate including a wiring electrically connected to the plurality of semiconductor light emitting elements,
wherein at least one of the plurality of semiconductor light emitting elements includes:
a first conductive electrode layer;
a first conductive semiconductor layer electrically connected to the first conductive electrode layer and positioned on the first conductive electrode layer;
an active layer positioned on the first conductive semiconductor layer;
a second conductive semiconductor layer positioned on the active layer, wherein the second conductive semiconductor layer includes an upper surface, a connecting surface formed adjacent to the upper surface at a first angle relative to the upper surface, and a side surface formed adjacent to the connecting surface at a second angle relative to the upper surface;
a second conductive electrode layer electrically connected to the second conductive semiconductor layer and positioned on at least a portion of the upper surface of the second conductive semiconductor layer; and
a passivation layer surrounding at least a portion of the semiconductor light emitting element.

11. The display device of claim 10, further comprising an upper wiring connected to at least a portion of the second conductive electrode layer,
wherein at least a portion of the passivation layer includes a first corresponding area surrounding the connecting surface of the second conductive semiconductor layer, wherein the first corresponding area is formed corresponding to a shape of the surrounded connecting surface,
wherein at least a portion of the upper wiring includes a second corresponding area formed on at least a portion of the passivation layer, wherein the second corresponding area is formed corresponding to the shape of the surrounded connecting surface.

12. The display device of claim 10, wherein the connecting surface includes n surfaces, and each of the n surfaces is adjacent to the others with an inclination greater than 90 degrees and smaller than 180 degrees relative to each other.

13. The display device of claim 10, wherein the connecting surface is a curved surface having a predetermined curvature.

14. The display device of claim 10, wherein the semiconductor light emitting element is a micro light emitting diode (micro LED) with a size in micrometers.

15. A method for manufacturing a display device, the method comprising:
forming a semiconductor light emitting structure on a growing substrate and etching an upper portion of the semiconductor light emitting structure;
transferring the semiconductor light emitting structure onto a transfer substrate;
forming an electrode layer on the transferred semiconductor light emitting structure to form a semiconductor light emitting element; and
assembling the semiconductor light emitting element on a wiring substrate.

16. The method of claim 15, wherein the etching of the upper portion of the semiconductor light emitting structure includes:
etching an edge of a upper surface of the semiconductor light emitting structure; and
etching at least a portion of a side surface of the semiconductor light emitting structure.

17. The method of claim 16, wherein the etching of the edge of the upper surface of the semiconductor light emitting structure includes:
performing a first etching on at least a portion of the upper portion of the semiconductor light emitting structure at a first etching rate; and
performing a second etching on the first-etched at least a portion of the upper portion of the semiconductor light emitting structure at a second etching rate.

18. The method of claim 17, wherein the second etching rate is higher than the first etching rate.

19. The method of claim 18, wherein the etching of the at least a portion of the side surface of the semiconductor light emitting structure includes etching the second-etched at least a portion of the semiconductor light emitting structure at a third etching rate higher than the second etching rate.
